(19) Europäisches Patentamt
European Patent Office
Office européen des brevets

(11) Publication number: 0 522 842 B1

(12) EUROPEAN PATENT SPECIFICATION

(45) Date of publication of patent specification: 20.09.95

(51) Int. Cl.6: **C30B 29/04**, C30B 25/00, C23C 16/26

(21) Application number: 92306274.9

(22) Date of filing: 08.07.92

(54) **Method and apparatus for synthesizing diamond in vapor phase.**

(30) Priority: 10.07.91 JP 197109/91
09.08.91 JP 225100/91

(43) Date of publication of application:
13.01.93 Bulletin 93/02

(45) Publication of the grant of the patent:
20.09.95 Bulletin 95/38

(84) Designated Contracting States:
DE FR GB

(56) References cited:

PATENT ABSTRACTS OF JAPAN, unexamined applications, C field, vol. 13, no. 447, October 06, 1989 THE PATENT OFFICE JAPANESE GOVERNMENT page 116 C 642

PATENT ABSTRACTS OF JAPAN, unexamined applications, C field, vol. 13, no. 427, September 22, 1989 THE PATENT OFFICE JAPANESE GOVERNMENT page 108 C 639

(73) Proprietor: SUMITOMO ELECTRIC INDUSTRIES, LIMITED
5-33, Kitahama 4-chome
Chuo-ku
Osaka 541 (JP)

(72) Inventor: Ikegawa, Akihiko, Itami Works of Sumitomo
Electr. Ind. Ltd.,
1-1 Koyakita 1-chome
Itami-shi,
Hyogo (JP)
Inventor: Fujimori, Naoji, Itami Works of Sumitomo
Electr. Ind. Ltd.,
1-1 Koyakita 1-chome
Itami-shi,
Hyogo (JP)
Inventor: Yoshikawa, Masanori
3-25-16, Maruyamadai,
Konan-ku
Yokohama-shi,
Kanagawa-ken (JP)

(74) Representative: Smith, Norman Ian et al
F.J. CLEVELAND & COMPANY
40-43 Chancery Lane
London WC2A 1JO (GB)

**Description**

This invention relates to a method and apparatus of synthesizing diamond in vapor phase. Especially, it relates to a vapor phase method and apparatus which allow us to make a wide diamond of high quality in a short time in vapor phase.

This application claims the priority of Japanese Patent Applications No. 197109/1991 filed July 10, 1991 and No225100/1991 filed August 9, 1991, which are incorporated herein by reference.

Various methods for synthesizing diamond in vapor phase have been known. These methods are classified by the way how to dissolve and activate material gas.

(1) Thermal Filament CVD Method... activating material gas by thermal electrons emitted from a heated filament at a high temperature.

(2) Microwave Plasma CVD Method... activating material gas by microwave plasma.

(3) DC plasma CVD Method ... activating material gas by DC hot plasma.

(4) Arc Plasma Jet CVD Method ... activating material gas by arc plasma jet utilizing DC plasma torch or RF plasma torch.

(5) Burner Method ... activating material gas by oxygen acetylene flame.

The inventors think that a favorable method for synthesizing diamond at high speed is the DC plasma jet method which utilizes DC plasma torches. This invention is an improvement of the DC plasma jet method. Many proposals have been presented with regard to DC plasma jet methods. They have advantages and drawbacks in any way. Prior methods will be explained in short.

(1) Japanese Patent Laying Open No.64-33096 ( 33096/1989 )

A torch for plasma spraying was used for synthesizing diamond. A plasma torch has a cylindrical anode and a columnar cathode enclosed by the anode. Plasma jet is produced by the steps of applying DC voltage between the cylindrical anode and a columnar cathode, supplying a carbon-containing gas, hydrogen gas and argon gas to a nozzle installed between the anode and the cathode, generating arc discharge, converting the gas into plasma and spurting the plasma with the discharge gas from the nozzle. This method utilizes untransferable, inner discharge. The gas for making plasma is a material gas including carbon itself. Namely, the gas to make plasma is not distinguished from the material gas. A material gas including carbon passes through a gap between the cathode and the anode. Since the nozzle ejects gases with so high speed, that they form a jet flow. Furthermore, it utilizes hot plasma. The jet flow and the hot plasma allow the method to excel in high speed deposition. However, since the method makes a carbon-containing gas flow through a gap between the anode and the cathode, surfaces of electrodes mainly near the outlet are likely to be covered with carbon deposition. Deposition of carbon makes the arc discharge unstable. Stable discharge cannot hold in the torch owing to the carbon deposition for a long time.

Furthermore, this device would be insufficient to deposit diamond films with a wide area.

In order to solve the difficulty of the carbon deposition on the electrodes, Japanese Patent Laying Open No.64-33096 had proposed an improvement of forbidding the carbon containing gas from flowing through the inner space of a plasma torch. Namely, such a gas without carbon flows in the nozzle and a carbon containing gas is forced to blow to the plasma jet from a side of the stream. Since carbon does not pass through the inner space of the torch, the inner space is immune from carbon contamination. Although this improvement would be effective for a small plasma jet with slow velocity, other problems remains for a big, rapid plasma jet. Large inertia of the big, rapid plasma flow will prevent a centripetal flow of a carbon-containing gas from attaining to the central part of the plasma jet. Thus, the carbon containing gas cannot be effectively dissolved and activated. The improvement fails in full exploitation of a carbon-containing gas.

(2) Japanese Patent Laying Open No.1-179789 ( 179789/1989 )

The torch has a cathode at the center. A bore is perforated in the cathode through which a carbon-containing gas is supplied in the torch. The surface of an anode or a cathode will not be contaminated by carbon. However, since the gas outlet of the carbon-containing gas appears in plasma, carbon will deposit on the gas outlet. The deposition of carbon will unstabilize the state of discharge. As the size of the outlet is so narrow, a little deposition of carbon easily changes the state of discharge.

In general, DC arc plasma jet method excels in the speed of synthesis of diamond. Some report says that the method will exhibit a maximum deposition speed of 100 $\mu$m/h of diamond. In spite of the high speed of deposition, it is insufficient to produce wide diamond films. If a wide diamond cannot be synthesized, the object of the diamond will be confined and the production cost will be raised. Besides, it suffers from the instability of the state of discharge owing to carbon deposition on the surfaces of electrodes. Thus, the drawbacks of DC plasma jet methods, i.e. a narrow deposition area, and instability of discharge have not been solved yet.

A large plasma torch and big supply of power would enable us to obtain a wide diamond film. Someone attempted to enlarge a plasma torch. But since the plasma is generated by arc discharge, enlargement of the plasma torch will accompany widening of the area of discharge. Widening of discharge will induce instability of arc discharge. Maintenance of large plasma jets requires a vast amount of gas supply. Restriction of gas supply confines the maximum size of a torch. Even if a single torch would be enlarged to the maximum, a deposition area more than 50 mm (2 inches) in diameter could not be obtained by a single torch.

Big supply of power would heat electrodes vehemently and might melt them out. To avoid melting of the electrodes, they are usually cooled by letting water flow in inner spaces of the electrodes or blowing sheath gas to the surfaces of the electrodes Restriction of cooling performance for the electrodes confines the maximum supply of power for them. Thus, the power cannot be increased over a limit determined by the cooling performance.

(3) Japanese Patent Laying Open No.1-172294 ( 172294/1989 )

A single plasma torch produces only a small diamond film with narrow area. Enlargement of a torch is ineffective owing to instability of discharge and restriction of cooling performance. Then plural plasma torches of the same structure aligned side by side would be effective, since a big plasma stream would be obtained by confluence of individual plasma streams. For example, Japanese Patent Laying Open No.1-172294 uses two equivalent torches aligned side by side. A bigger stream could be formed. However, this method combined two streams as it is. Density of plasma is not uniform but extremely irregular at the center or in the periphery. Irregular distribution of plasma in the combined stream will make a film with large fluctuation of thickness or quality. Such an irregular film deposition resulted from primitive alignment of equivalent torches.

(4) Japanese Patent Laying Open No. 61-259778 ( 259778/1986 )

All of prior art mentioned so far excite arc discharge in a single plasma torch and generate plasma in a torch. Such a plasma jet made by the isolated torches is called an untransferable, inner plasma jet. An untransferable plasma torch produces a high temperature and high speed plasma jet. But ultrahigh temperature and high speed of plasma jet are likely to melt electrodes down and forbid a longterm, continual operation of deposition. Inert gases are available for producing plasma. No carbon containing gas could be used for a plasma-producing gas.

Another type of arc discharge held between plural torches has been devised in order to solve these difficulties. Japanese Patent Laying Open No.61-259778 installs a pair of a plasma torch which will act as an anode and another plasma torch which will act as a cathode in a vacuum chamber. An individual torch has a core cathode, a first outer electrode and a second outer electrode for anodes. At first, inner plasma discharge is induced in individual torches by applying voltage between the cathode and the anode of the individual ones. Then, the inner plasma discharge will be converted into an external plasma held between a torch as a cathode and another torch as an anode by the steps ;

(a) Stopping applying voltage between the anode and the cathode of the torch acting as a cathode (a cathode-torch in short hereafter ) for stopping discharge between the anode and the cathode of the torch,

(b) Applying voltage by the same power supply which has been applied between the anode and the cathode of the cathode-torch, between the cathode of the cathode-torch and the anode of the anode-torch at the same time of step (a),

(c) Stopping applying voltage between the anode and the cathode of the anode-torch for stopping the discharge between the anode and cathode of the anode-torch,

(d) Producing a transferable, outer plasma jet between the cathode of the cathode-torch and the anode of the anode-torch,

This method allows the torches to form a wide, transferable, outer plasma jet instead of narrow untransferable plasma jets which are kept between a cathode and an anode of the same torch. In the transferable outer plasma jet, an arc occurring from a cathode of a cathode-torch passes through a nozzle between a first outer electrode and a second outer electrode of a cathode-torch, goes out from the torch, forms a hair-pin like arc-column and enters an anode point of an anode of an anode-torch. A beginning point on the cathode of the cathode-torch and an end point on the anode of the anode-torch of the transferable plasma jet are securely fixed. Fixation of the points stabilizes the arc column for a long time. Therefore, the instability of arc in the isolated, untransferable torch is resolved by the transferable jet. Japanese Patent Laying Open No.61-259779 has another feature. It has proposed a new torch having three electrodes, i.e. a central cathode, a first cylindrical anode and a second cylindrical anode which are coaxially disposed around a center line. Two separated spaces ; a space between the cathode and the first anode and another space between the first anode and the second anode, are provided for a torch. Gases can be supplied to both of two separated spaces. Namely, inert gas will be let flow in the first space between the cathode and the first anode in the cathode-torch for protecting the inner cathode from plasma, when a transferable outer plasma column has been once established. Similarly inert gas will be let flow in the second space between the first and second anodes for protecting the inner anode of the anode-torch then.

As mentioned so far, some methods for generating an outer plasma jet among plural torches have been already proposed. In the methods, individual torches must make an individual discharge in themselves. The preparatory discharge is indispensable for inducing an outer discharge among the torches. If voltage was applied between the cathode of the cathode-torch and the anode of the anode-torch without preparatory plasma arcs, no outer discharge would happen. When a transferable, outer discharge has been established, the original, inner discharge in individual torches is turned off. They have an advantage that the electrodes are protected by the gas flow of inert gas during the outer discharge being kept.

(5) Japanese Patent Laying Open No.2-248397 ( 248397/1990 )

An outer plasma jet is formed among plural torches also in the invention. The features will be explained here ;

(a) Two plasma torches are disposed in a relation in which extensions of central axes of two torches meet at a point. An outer, transferable arc plasma is born between a cathode of a torch ( cathode-torch ) and an anode of another torch ( anode-torch ). A substrate body is placed at a point on extension of the central axial line of the cathode-torch. A diamond film will be grown on the substrate body.

(b) A torch has a three-fold, coaxial structure of electrodes. A cathode bar is mounted at the center. Two coaxial anodes enclose the cathode. Inner cylindrical anode is called a first outer electrode. Outer cylindrical anode is called a second outer electrode. Otherwise, the inner anode is simply called an anode, and the outer anode is called an outer electrode. Gas passageways are formed between the cathode and the first outer electrode and between the first outer electrode and the second outer electrode. Gas can flow in the passageways from the bottom ends to the front ends. The three-fold electrodes effectively contribute to protecting the electrodes against heat during the external discharge in action. A transferable, outer discharge spans a cathode of a cathode-torch and an inner anode of a anode-torch ( first outer electrode ). In the cathode-torch, the cathode is protected by letting inert gas flow in the first space between the cathode and the first outer electrode. In the anode-torch, the first outer electrode ( anode ) is protected by letting inert gas flow in the second space between the first outer electrode and the second outer electrode. Since inert gas contains no carbon, the electrodes are not contaminated by carbon deposition. It is preferable to let hydrogen gas flow in other gas passageways, i.e. the space between the first outer electrode and the second outer electrode of the cathode-torch. Hydrogen gas is unlikely to induce instability of discharge. Vapor-phase reaction of hydrogen gas would not bring about deposition on electrodes Without such bad effects, hydrogen gas cools electrodes.

(c) Carbon-containing gas will be sprayed to the plasma jet from a separated nozzle.

Japanese patent Laying Open NO.2-248397 has succeeded in constructing a DC plasma jet apparatus in which carbon does not deposit on electrodes, inert gas effectively protects anodes and cathodes and longterm, stable operation is realized by the improvements mentioned.

As explained at first, the DC plasma jet method excels in high speed deposition but it cannot still conquer the difficulty of instability of discharge. Japanese Patent Laying Open No. 61-259778 and No. 2-248397 have resolved the requirement for longterm stability of plasma arc by replacing untransferable, inner plasma arc by transferable, outer plasma arc.

However, the other important requirement for widening the formation area of diamond has not been resolved yet by these proposals. Besides the requirement for widening, these improvements have been still accompanied by other difficulty that sufficient amount of carbon cannot be introduced into the middle part of plasma jet in the case of a wide plasma jet, because carbon containing gas is sprayed from sides of the jet in order to avoid contamination of electrodes by carbon. Ununiform activation of a carbon-containing gas causes ununiform thickness of a film.

A purpose of this invention is to provide a method and apparatus for synthesizing diamond with a wide area of synthesis by utilizing a DC plasma jet method which is inherently superior in high speed of deposition. Namely, the requirements of high speed synthesis and stability of plasma have been resolved so far if the plasma area is small. However, the requirement for a wide area of synthesis has not been resolved yet. This invention will conquer the last difficulty of DC plasma jet method. The inventors have intensively sought for a new method which enables us to enlarge the synthesis area without impairing the advantages of DC plasma jet, i.e. high quality, high speed of deposition.

This invention uses plural plasma torches. Some of them act as an anode. Thus, they are called an anode-torch. The others act as a cathode. They are called a cathode-torch. Initially all plasma torches are turned on for building up individual plasma arcs by applying voltage between their inherent anode and cathode. This is called an untransferable, inner plasma arc. Then, the inner plasma arcs are coupled for forming an associated plasma arc by supplying voltage between pertinent electrodes of the torches. This is called a transferable, outer plasma arc jet. The transferable plasma arcs are assembled to a wider, associated plasma jet. Then, the associated plasma jet will be enlarged by displacing the torches or rotating the torches. Such a dynamical enlargement is one of the most conspicuous features of this invention.

One aspect of this invention provides a method for synthesizing diamond by decomposing and activating a material gas by DC plasma generated by a DC voltage applied between an anode and a cathode of a plasma torch and by spraying activated plasma on a substrate body, comprising the steps of disposing more than three plasma torches such that an extension of the central axis of each torch meets the extension of the other torches at a point and such that said axes are not aligned along a straight line and are not parallel to each other, the plasma torch having anodes and cathodes in coaxial relation and gas passageways between the anodes and cathodes, the plasma torch being capable of forming an untransferable, inner DC arc plasma jet, at least one of the plasma torches acting as a cathode (a cathode-torch), the other plasma torches acting as anodes (anode-torches), letting an insert gas or a mixture of an inert gas and hydrogen gas flow in passageways between the cathode and the anode of the individual plasma torches, applying a voltage between the anode and the cathode of the individual plasma torches, yielding untransferable, inner DC plasma jets, stopping the inner discharge in the individual torches, associating plural transferable, outer plasma jets together, forming a wide, uniform associated plasma jet, spurting a carbon-containing gas or mixture of hydrogen gas and a carbon-containing gas towards the confluences of the plasma jets, and spraying the plasma jet on a substrate body positioned in a stream of the plasma jets, and depositing diamond synthesized in a vapor phase reaction on the substrate body.

Another aspect of the invention provides an apparatus for synthesizing diamond by dissolving and activating a material gas by DC plasma generated by a DC voltage applied between an anode and a cathode of a plasma torch and by spraying activated plasma on a substrate body, comprising a vacuum chamber, a vacuum pump for creating a vacuum in the vacuum chamber, a supporter for holding the substrate body in the vacuum chamber, a plurality of plasma torches located in the vacuum chamber for producing a DC plasma jet, each plasma torch having a cathode bar and anodes mounted coaxially around a central axis, the plasma torches being arranged in a conical arrangement, such that an extension of the central axes of each torch meets the extension of the other torches at a point, a plurality of nozzles for spurting a carbon-containing gas into the DC plasma jets created by the plasma torches, power sources for supplying a DC voltage or a DC voltage superposed with an RF voltage between cathodes and anodes of the plasma torches, electrical connections for connecting plural plasma torches to the power sources, plural switches provided in the electrical connections for turning on or turning off the voltage supply to the cathodes or anodes of the torches, the arrangement being such that, in use, some of the plasma torches act as cathodes (cathode-torches), and the other of the plasma torches acting as anodes (anode-torches), the plasma torches being capable of forming individual arc plasma columns in them in response to application of a voltage between the cathode and the anode, and the anode-torches and the cathode-torches being capable of forming a wide, associated plasma arc jet in response to operation of the switches.

Instead of the untransferable, inner plasma jet, this invention makes transferable, outer plasma jets between torches. The plasma torches are not all equivalent but different in role for producing the outer plasma jets. Some torches are connected with positive poles of DC power supplies and the others are connected with negative poles of DC power supplies. The former ones acting as anodes are called now anode-torches. The latter ones acting as cathodes are called cathode-torches for simplicity. Such a different role of plasma torches is one of the features of this invention.

The transferable plasma jets are associated in a wider plasma jet. Then, the associated, wide plasma jet is enlarged by displacing or rotating plasma torches. Such a dynamical expansion of plasma jet is another one of the features of this invention.

Only inert gas or hydrogen gas passes through the passageways in plasma torches. Electrodes of torches are fully immune from carbon deposition. A material gas containing carbon does not pass in torches.

A carbon-containing gas is spurted by nozzles to the confluences of the plasma jets yielded by cathode-torches and the plasma jets yielded by anode-torches. Since sections of the plasma jets are not so large, the carbon-containing gas can be penetrated uniformly in the plasma jets. After plasma jets have inhaled enough carbon, all plasma jets unite with together into an associated jet. The associated jet is a wide jet which could not be obtained by any prior art.

It is preferable that the number of nozzles for spurting a carbon-containing gas should be equal to the number of confluences of plasma jets from anode-torches and plasma jets from cathode-torches. For example, if the number M of cathode-torches is 1 and the number N of anode-torches is 3, the number of confluences is three. In this case, three nozzles should be used preferably.

If two cathode-torches ( M = 2 ) and two anode-torches ( N = 2 ) are installed, the plasma jets from cathode-torches and from anode-torches make four confluences. It is desirable to provide four nozzles for spurting a carbon-containing gas into the confluences.

However, at least two nozzles placed at symmetrical position are enough to spurt a carbon-containing gas into the plasma jets uniformly in general.

In short, this invention makes individual torches produce inner, untransferable discharge at first. Then, the inner, independent discharge is converted into outer, transferable discharge by special operations. Finally, the plasma formation area is enlarged by displacing or rotating torches. The steps will be explained more in detail. Transferable, outer plasma jets between plural plasma torches can be formed by the following methods ;

(1) One cathode-torch and plural anode-torches yield transferable, outer plasma jets therebetween. ( M = 1, N ≥ 2 )

(2) One anode-torch and plural cathode-torches yield transferable, outer plasma jets therebetween. ( M ≥ 2, N = 1 )

(3) One cathode-torch and plural anode-torches yield transferable plasma jets and one anode-torch and plural cathode-torches make another transferable plasma jets at the same time.

In any cases, transferable plasma jets will be formed by the following steps. All plasma torches which can yield an inner untransferable plasma jet are divided into cathode-torches and anode-torches according to the roles for producing and keeping transferable plasma jets. In an initial disposition, extensions of central axis of cathode-torches meet with extensions of central axes of anode-torches at a point. Namely, anode-torches and cathode-torches lie on two imaginary cones which face together at their tops. The distance between the anode-torches and the cathode-torches is small. At first, inner, untransferable plasma jets are formed in individual torches by applying DC voltage between the inner anode and inner cathode of the same torches. Secondly, transferable arc plasma jets between cathode-torches and anode-torches are formed by applying DC voltage between pertinent electrodes of the torches. Finally, the area of the plasma jets is widened by displacing or rotating the torches. This invention features such dynamical widening of the plasma jet area.

In prior art mentioned before, Japanese Patent Laying Open No. 61-259778 and No. 2-248397 have proposed transferable, outer plasma between two plasma torches. These proposals correspond to the simplest case of M = 1 and N = 1. Since the outer plasma is only one, it is not effective to widen the plasma area. They had only one confluence of plasma jets from an anode-torch and a cathode-torch.

This invention features an inequality of M + N ≥ 3 with regard to the number M of cathode-torches and the number N of anode-torches. The number of confluences of plasma jets from cathode-torches and plasma jets from anode-torches is at most MN in a good disposition. The inequality M + N ≥ 3 signifies more than two confluences. As the plasma jets have more than two confluences, the area of plasma jets is bigger than the case of M = 1 and N = 1. The more the confluences increase, the wider the plasma jet area of associated plasma becomes. This is a geometric increment of plasma area by increasing the number of torches. Furthermore, this invention enlarges the plasma area by moving or rotating torches. This is a dynamical increment of plasma area. Geometric increment and dynamic increment characterize this invention. This invention allows us to synthesize a diamond film of a large area by spraying a wide plasma jet to a substrate body.

The plasma jet area can be enlarged by moving or rotating plasma torches in different modes, e.g. in the case of one cathode-torch and plural anode-torches ( M = 1, N ≥ 2 ).

(1) Parallel transference of anode-torches along their central axes in the direction of receding from the cathode-torch,

6

(2) Parallel transference of the cathode-torch along its central axis in the direction of receding from anode-torches,

(3) Rotation of anode-torches in the direction of making the extensions of the central axes recede from the cathode-torch,

(4) Rotation of both cathode-torch and anode-torches in the directions of making the extensions of the central axes deviate from the initial confluence 0.

All modes will be effective to enhance the plasma formation area. In practice, some of four modes will be utilized at the same time. In the case of plural cathode-torches ( $M \geq 2$, $N \geq 2$ ), besides modes (1) to (4), other modes are also available.

(5) Parallel transference of cathode-torches in the direction of receding together,

(6) Rotating cathode-torches in the direction of enlarging the associated plasma area.

This invention forbids a carbon-containing gas from passing through the passageways of torches. Thus, surfaces of electrodes of plasma torches are not contaminated by carbon deposition. Gas nozzles are provided near the confluences of plasma jets for spurting a carbon-containing gas to the confluences of the cathode-torch jets and anode-torch jets. As mentioned before, the plasma torches are moved or rotated at the final stage for enlarging plasma jets. These displacements of torches accompany deviation of confluences. Therefore, the nozzles for spurting a carbon-containing gas should be displaced according to the displacement of the confluences in order to spurt a carbon-containing gas to optimum spots in the plasma jets. Thus, it is preferable to provide the gas nozzles with an apparatus for displacing the nozzles.

Functions of the invention will be explained. Prior art had proposed an apparatus having a cathode-torch and an anode-torch for producing an outer, transferable plasma jet with one confluence ( $M = 1$, $N = 1$ ). This invention uses more than three plasma torches. An outer plasma jet is generated between the cathode of a cathode-torch and the anode of an anode-torch ( first outer electrode ). The number M of cathode-torches is not necessarily equal to the number N of anode-torches. A case of $M = 1$ and $N \geq 2$ is allowable. Another case of $M \geq 2$ and $N = 1$ is also available. Of course, in general, such case of $M \geq 2$ and $N \geq 2$ is possible.

In the case of single cathode-torch and plural anode-torches ( $M = 1$, $N \geq 2$ ), anode-torches should preferably be arranged at positions which are rotationally symmetric to the extension of a central axis of the cathode-torch and in which the extensions of central axes of the anode-torches meet at a point along the central axis of the cathode-torch. In the mode, the cathode-torch and anode-torches form N confluences. Gas nozzles for spurting a carbon-containing gas or a carbon-hydrogen-containing gas to N confluences should be installed. This is a static disposition at the initial state. Preferably the number of nozzles is N. When outer plasma jets are turned on, the plasma jet area is enlarged by moving or rotating plasma torches. Movement of the torches accompanies displacement of confluences. Positions and directions of nozzles should be change in order to spurt a carbon-containing gas to optimum positions of the jets.

More detailed explanation is given now in the same case of $M = 1$ and $N \geq 2$. The central axis of the cathode-torch is denoted by z-axis. The point at which the extensions of all torches meet is assigned to the origin of coordinate. P is the center of the cathode-torch and $Q_1$, $Q_2$, ..... are centers of anode-torches. Assuming $OP = g$, $OQ_1 = OQ_2 = OQ_3 = ....... = h$, $<POQ_1 = \Theta$ and $2\pi /N = \Phi$, centers of the cathode-torch and anode-torches are expressed by;

$$\text{cathode-torch } P ( 0, 0, g )  \qquad\qquad (1)$$

anode-torch    $Q_1$ (   $h \sin\Theta \cos\Phi$,   $h \sin\Theta \sin\Phi$,   $h \cos\Theta$ )   (2)

$Q_2$ ( $h \sin\Theta \cos2\Phi$,   $h \sin\Theta \sin2\Phi$,   $h \cos\Theta$ )   (3)

$Q_3$ ( $h \sin\Theta \cos3\Phi$,   $h \sin\Theta \sin3\Phi$,   $h \cos\Theta$ )

• • • • • • • • • • • • • • • • • • • • • • • • • • • • • • • • • • • • • • • • • • • • ·

$Q_N$ (        $h \sin\Theta$,                0,  $h \cos\Theta$ )   (4)

Directions of the torches are expressed by unit vectors $p$, $q_1$, $q_2$, ...... .

cathode-torch $p$ ( 0, 0, -1 )                          (5)

anode-torch    $q_1$ (   $-\sin\Theta \cos\Phi$,   $-\sin\Theta \sin\Phi$,   $-\cos\Theta$ )        (6)

$q_2$ ( $-\sin\Theta \cos2\Phi$,   $-\sin\Theta \sin2\Phi$,   $-\cos\Theta$ )        (7)

• • • • • • • • • • • • • • • • • • • • • • • • • • • • • • • • • • • • • • • • • • • •

$q_N$ (        $-\sin\Theta$,           0,  $-\cos\Theta$ )      (8)

Of corse in the initial state, position vectors and direction vectors of the torches are antiparallel.

In the case of plural cathode-torches and plural anode-torches, the torches should be arranged along generating lines on two imaginary cones facing each other. Peak points of the cones coincide at a point. However, if M = N, planes including anode-torch and z-axis should not coincide with planes including cathode-torch and z-axis. Namely, for N anode-torches and N cathode-torches, a unit angle $\phi$ is defined by $\phi = 2\pi /2N = \pi /N$.

The center line of imaginary cones is z-axis in the case. The inclination angle of the cathode-torches to Z-axis is denoted by $\theta$. The centers of anode- and cathode-torches are represented by ;

| | |
|---|---|
| 1st cathode-torch $P_1$ ( $g \sin\theta \cos\phi$, $g \sin\theta \sin\phi$, $g \cos\theta$ ) | (9) |
| 1st anode-torch $Q_1$ ( $h \sin\Theta \cos2\phi$, $h \sin\Theta \sin2\phi$, $h \cos\Theta$ ) | (10) |
| 2nd cathode-torch $P_2$ ( $g \sin\theta \cos3\phi$, $g \sin\theta \sin3\phi$, $g \cos\theta$ ) | (11) |
| 2nd anode-torch $Q_2$ ( $h \sin\Theta \cos4\phi$, $h \sin\Theta \sin4\phi$, $h \cos\Theta$ ) | (12) |

If M = N, such a symmetric arrangement is desirable. Even if M ≠ N, a symmetric arrangement can be available, when M and N have a big largest common measure.

In these dispositions of plasma torches, at first inner plasma jets are yielded in individual torches irrespectively of anode- or cathode-torches. Secondly, the individual plasma jets are converted into outer transferable plasma jets. Finally, the plasma jet area is enhanced by moving the torches. Various modes for enlarging the plasma jet area are available as mentioned before.

(1) Parallel transference of anode-torches along their center lines to the direction for receding from the cathode-torch,

(2) Parallel transference of cathode-torches along their center lines to the direction of receding from the anode-torch.

(3) Inclining anode-torches for letting the extensions of the center lines deviate from the cathode-torches,

(4) Rotating anode-torches with the extensions of center lines of anode-torches deviating from the cross point O.

Some pertinent modes shall be selected for enlarging the plasma area. Modes 1 to 4 are pertinent for the case of M = 1 and N ≥ 2. Other cases have equivalent modes for moving the torches.

Mode 1 moves anode-torches in parallel along their axes for receding from origin O ( confluence of jets ), which corresponds to increase of h in Eqs.(2) to (4). Mode 2 which moves cathode-torches to the directions of receding from origin O corresponds to increase of g in Eq.(1). Mode 3 does not move anode-torches in parallel, but changes direction vectors by reducing $\Theta$ in Eqs.(6) to (8). Mode 4 changes angular parameters $\Phi$ or $2\Phi$ to $\Phi + \epsilon$ or $2\Phi + \epsilon$, where $\epsilon$ is a small angle. Besides the change of $\Phi$, $\Theta$ may be reduced.

If more than two cathode-torches are used ( M ≥ 2 ), another mode of moving cathode-torches in the directions for receding each other becomes available. This mode corresponds to enlarging the imaginary cone which determines the positions and directions of cathode-torches. Namely in Eq.(9), $g \sin\theta \cos\phi$ shall be enhanced to $g \sin\theta \cos\phi \times \alpha$ and $g \sin\theta \sin\phi$ shall be enhanced to $g \sin\theta \sin\phi \times \alpha$ ( $\alpha > 1$ ).

On the contrary, another mode for enlarging the plasma area by inclining the cathode-torches toward the directions in which the imaginary cones diminish is also applicable. In the mode, the crossing point of extensions of anode-torches is displaced by $\beta$ in z-direction. At the same time, the inclination angle $\theta$ between z-axis and cathode-torches is reduced.

Besides the movement or rotation of torches, the plasma jet area can be adjusted by the following parameters ;

(a) Shape of nozzle part of plasma torches,

(b) Gas flux ejected from nozzles of plasma torches,

(c) Component of gas for producing plasma,

(d) Electric power for maintaining plasma,

(e) Pressure for producing plasma jets,

(f) Shape, positions of outlet, and gas flux of a carbon-containing gas.

Advantages of this invention will now be explained.

(1) The method and apparatus for producing diamond of this invention allow us to make a large plasma jet area by producing inner untransferable plasma jets, converting them into outer transferable plasma jets and associating them in a united one.

(2) Besides the static enlargement of plasma jet area, this invention further widens the plasma area by dynamical operations. The outer, transferable plasma jet is further enlarged by parallel transference or rotation of torches in the direction of receding each other or in the directions in which center lines of torches deviate from the initial crossing point.

(3) If a carbon-containing gas flowed in passageways of plasma torches, electrodes of the torches would be contaminated by carbon deposition, which would unstabilize the discharge. Prior art have failed to solve the instability of discharge. This invention forbids a carbon-containing gas from flowing in passageways of plasma torches. Only inert gas or hydrogen gas flows in torches. Electrodes of torches are fully immune from carbon contamination. The difficulty of instability of discharge is solved. A carbon-containing gas shall be spurted from other nozzles to the confluences of outer plasma jets. Freedom from carbon deposition allows torches to keep plasma jets stable for a long time.

(5) Carbon-gas-supplying nozzles spurt a carbon-containing gas to the confluences of plasma jets from one pair of anode-torch and cathode-torch. Since the section of the plasma jets is small at the confluences, the carbon-containing gas can uniformly attain to central portion of jets. The plasma gas contains uniformly-distributed carbon. The uniformly carbon-distributed plasma jet enables us to synthesize a wide diamond film with uniform property on a wide substrate body.

(6) This invention features flexibility. The plasma jet area can unlimitedly be expanded by increasing the numbers of cathode-torches and anode-torches.

(7) This invention allows plasma jet method to form a wide, uniform diamond film on a wide substrate body without impairing the most conspicuous advantage of plasma jet method, i.e. rapid synthesis. This is the most important advantage of this invention.

The invention will be more fully understood from the following description given by way of example only with reference to the several figures of the accompanying drawings in which,

Fig.1 is a schematic view of a first embodiment utilizing one cathode-torch and three anode-torches.

Fig.2 is a side view of plasma torches only with the cathode-torch shown in section.

9

Fig.3 is a sectional view of anode-torches with electric circuits for connecting torches and power sources. Fig.4 is perspective views for demonstrating modes of rotation or displacement of plasma torches for enhancing the plasma formation area. (a) shows an initial state, (b) shows parallel transference of torches for receding from each other, and (c) shows rotations of anode-torches as to induce discrepancy between extensions of anode-torches.

Fig.5 is a schematic view of an apparatus of a second embodiment of this invention utilizing two cathode-torches and two anode-torches.

Fig.6 is a sectional view of torches with electric circuits for connecting torches and power sources.

Fig.7 is perspective views for demonstrating modes of displacement or rotation of plasma torches for enhancing the plasma formation area. (a) shows an initial state, (b) shows recession of anode-torches or rotation of cathode-torches.

To achieve the foregoing objects and in accordance with the purpose of the invention, embodiments will be broadly described herein.

[ EMBODIMENT 1 ] ( M = 1 , N = 3 )

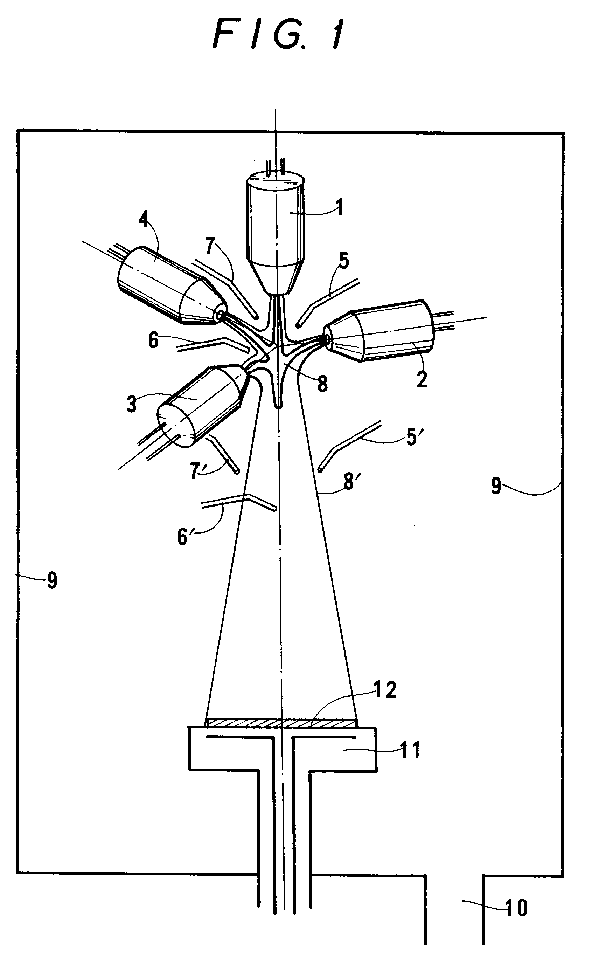

Embodiment 1 uses one cathode-torch and three anode-torches. Fig. 1 demonstrates an apparatus for making this invention into practice. Plasma torches are shown in perspective manner for clarifying the relation of torches. Plasma torches (1), (2), (3) and (4) have cathodes and anodes in coaxial relation therein which can yield plasma by generating arc discharge. Introducing gas into passageways from a rear end, the torch excites the gas by arc discharge into plasma, and gushes a plasma jet from a front nozzle. Among four torches, the torch (1) is used as a cathode, and the torches (2), (3) and (4) are used as anodes for forming outer, transferable plasma jets. Thus, (1) is called a cathode-torch and (2), (3) and (4) are called anode-torches in short.

Only inert gas or hydrogen gas flows in the passageways of torches. No carbon-containing gas passes through inner spaces of torches. The torches are immune from carbon deposition.

Set of gas supplying nozzles (5), (6) and (7) or another set of gas supplying nozzles (5′), (6′) and (7′) are installed around a plasma jet flame. Selection of the upper position or lower position depends on the size of a plasma jet flame. If the plasma jet is less than 50 mm in diameter, the lower position should be selected. Lower-positioned nozzles (5′), (6′) and (7′) can uniformly inject a carbon-containing gas into the associated plasma jet flame, because the flame is still thin enough for the gas flow gushing from the sides. If the plasma jet (8′) is more than 50 mm in diameter, the upper position of nozzles should be chosen for injecting a carbon-containing gas into the confluences of plasma jets from the cathode- and anode-torches. At the confluences the plasma jet is still thinner than the associated plasma jet flame ( more than 50 mm ). Thus, carbon can be injected into innermost of the plasma jet. Once uniformly-distributed carbon will be redistributed uniformly in the associated flame. In Fig.1, upper set of nozzles is shown by (5), (6) and (7). Gas nozzle (5) faces to the confluence of the gases from torches (1) and (2). Gas nozzle (6) faces to the confluence of the gases from torches (1) and (3). Gas nozzle (7) corresponds to the last confluence of the gases from torches (1) and (4).

Outer, transferable plasma jets (8) are produced between the cathode-torch (1) and the anode-torches (2), (3) and (4). The individual transferable plasma jets are associated into a bigger plasma flame (8′).

The plasma torches (1) to (4) and the gas supplying nozzles (5) to (7) or (5′) to (7′) are furnished in a vacuum chamber (9). The vacuum chamber (9) has a vacuum exhaust outlet (10) from which the chamber (9) can be made vacuous. A cooled susceptor (11) is installed below the plasma jet flame (8′) in the vacuum chamber (9). A substrate body (12) is placed on the susceptor (11). A diamond film will be grown on the substrate body (12). Since hot plasma jets flame (8′) launches the substrate body (12), the susceptor (11) must be cooled. In the embodiment, the susceptor (11) is effectively cooled by water.

Embodiment 1 has a cathode-torch (1) on z-axis, three anode-torches at positions 3-fold rotationally symmetric around z-axis with a center angle of 120°. Inclination angle θ of the anode-torches to z-axis is between 90° and 60°.

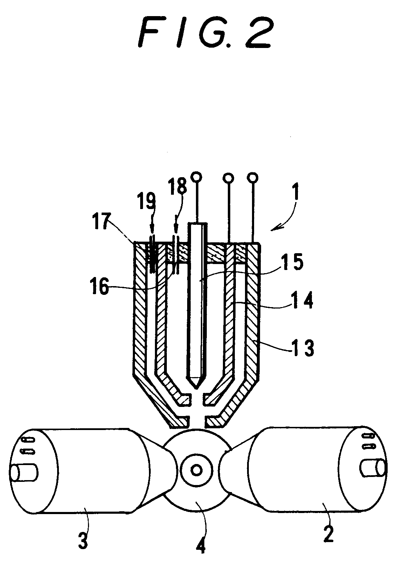

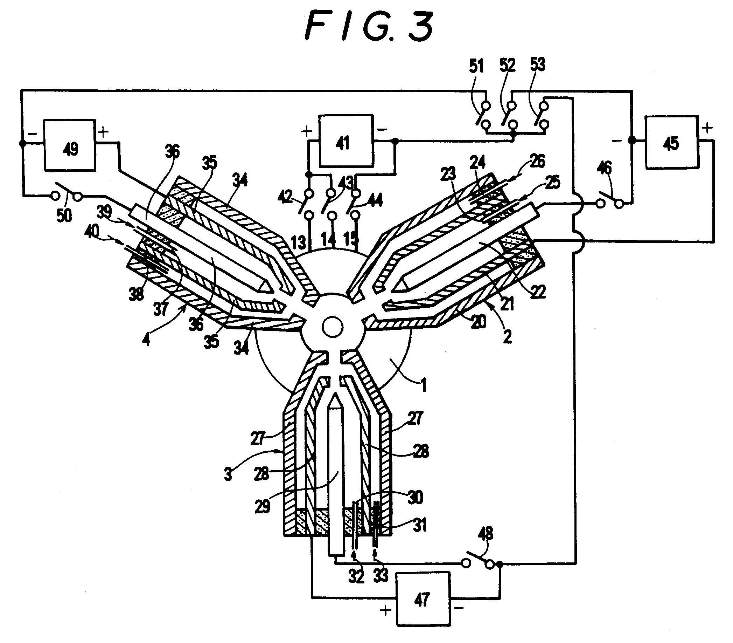

Fig.2 shows an example of θ = 90°. This is a side view of torches. The central cathode-torch (1) is shown by a section in order to demonstrate inner structure of the torch. Fig.3 demonstrates sections of anode-torches and electric circuits for connecting power sources to electrodes of torches. Three anode-torches are equivalent torches. But the cathode-torch is bigger than the anode-torches in power. Although substantial function of torches is the same and the structure is also the same, the bigger one (1) is called cathode-, and the smaller three are called anode- according to the functions when an outer transferable arc plasma is formed therebetween.

The cathode-torch (1) is a cylindrical device having three electrodes in coaxial relation ; from outer to inner, a second outer electrode (13), a first outer electrode (14) and a cathode bar (15). The outer electrodes are assigned to anodes. These electrodes are separated by insulators. The cathode bar (15) is made from tungsten (W). The outer electrodes (13) and (14) are made from copper (Cu). In practice, these electrodes (13), (14) and (15) have double walls in which cooling water flows to cool them. The cathode-bar (15) is cooled near the rear end. The first outer electrode (13) and the second outer electrode (14) taper at a front end off to a narrow outlet. A first gas inlet (16) pierces the rear insulator of the cathode-torch (1) for introducing a gas (18) into a passageway between the cathode bar (15) and the second outer electrode (14). Similarly a second gas inlet (17) is provided by piercing the rear insulator in order to introduce a gas (19) into a passageway between the first outer electrode (14) and the second electrode (13). A gas (18) and another gas (19) are introduced into the passageways of the torch (1). These gases are gases for producing plasma.

The anode-torches (2), (3) and (4) have the same structure as the cathode-torch (1). The anode-torch (2) is equipped with a second outer electrode (20), a first outer electrode (21) and a cathode bar (22) in coaxial relation. Gas inlets (23) and (24) piercing a rear insulating wall introduce gases (25) and (26) for producing plasma. The anode-torch (3) is provided with a second outer electrode (27), a first outer electrode (28) and a cathode bar (29) in coaxial relation. Gas inlets (30) and (31) introduce gases (32) and (33) for producing plasma. The anode-torch (4) is installed with a second outer electrode (34), a first outer electrode (35) and a cathode bar (36) in coaxial relation. Gases (39) and (40) for exciting plasma are introduced from gas inlets (37) and (38). With regard to the anode-torches, the second outer electrodes (20), (27) and (34) and the first outer electrodes (21), (28) and (35) have double walls in which cooling water flows. The cathode bars (22), (29) and (36) are cooled at the rear ends. All plasma torches let a gas flow in passageways between a cathode and anodes for producing plasma jets. The gas is an inert gas or a mixture of an inert gas and hydrogen gas, where an inert gas means Ar, Ne, He or Kr. No carbon-containing gas flows in the torches. Power sources accompany all plasma torches for applying a voltage between the inner electrodes in order to induce inner plasma arcs or for applying a voltage between the torches in order to induce outer plasma jets. The cathode-torch (1) is provided with a power source (41) which gives a DC voltage or a DC voltage superposed with an RF voltage to the electrodes of torches. When a plasma arc starts in the torch, the power source (41) supplies an RF-superposed DC voltage between the cathode bar and the first outer electrode of the torch. The RF-voltage superposed on a DC voltage facilitates occurrence of plasma arc. Other sources have a similar structure. As the power sources are essentially DC sources, they have a positive pole ( denoted by + ) and a negative pole ( denoted by - ). The negative pole of the power source (41) is connected via a switch (44) to the cathode bar (15). The positive pole is connected via a switch (42) to the second outer electrode (13) and via a switch (43) to the first outer electrode (14). Double anodes ( outer electrodes ) of torches ensure that the inner plasma arc will convert into an outer arc plasma for cathode torch and facilitate the protection of electrodes for anode torch by allowing a gas to flow in the passageway between the first and second outer electrodes. Therefore, two anodes (13) and (14) are alternately applied by voltage by turning on or off the switch (42) or (43). The anode-torch (2) is provided with a DC power source (45) which can superpose an RF-voltage on a main DC voltage. The negative pole of the power source (45) is connected via a switch (46) to the cathode bar (22). The positive pole is directly connected to the first outer electrode (21). The second outer electrode (20) is not connected to any power source.

The anode-torch (3) has a DC power source (47) which can superpose an RF-voltage on a main DC voltage. The negative pole of the power source (47) is connected via a switch (48) to the cathode bar (29). The positive pole is connected directly to the first outer electrode (28). The second outer electrode (27) is left unconnected.

The anode-torch (4) has also a DC power source (49) of the similar type. The negative pole is connected via a switch (50) to the cathode bar (36). The positive pole is connected directly to the first outer electrode (35). The second outer electrode (34) is left unconnected. In addition, switches (51), (52) and (53) are provided for intervening between the negative pole of the source (41) and negative poles the power of sources (49), (45) and (47) respectively.

Torches and switches will be operated in the following manners.

[1] In the vacuum chamber (9), a substrate body (12) is firmly fixed upon a cooled susceptor (11) in order to ensure sufficient heat transference therebetween. The cooled susceptor (11) is at first displaced at a lower position. The inner space of the vacuum chamber (9) Is made vacuous down to a pressure less than 0.133 pa ($1\times10^{-3}$ Torr). Then argon gas is introduced into the torches through the gas inlets (16), (17), (23), (30), (31), (37) and (38). The switches (43), (44), (46), (48) and (50) are turned on. The other switches (42), (51), (52) and (53) are left off.

[2] When the pressure in the vacuum chamber (9) attains to about $3 \times 10^4$ Pa (600 Torr), the power source (41) of the cathode torch (1) is actuated. The cathode bar (15) and the first outer electrode (14) form an inner, untransferable plasma arc. Short distance between the electrodes facilitates turning-on of the plasma.

[3] The switch (42) is turned on. The switch (43) is turned off. Anode voltage transfers from the first outer electrode (14) to the second outer electrode (13). Inner plasma is kept between the cathode bar (15) and the second outer electrode (13). This transference alleviates the difficulty of the conversion from inner plasma to outer plasma. In the step, only the cathode-torch (1) has an arc plasma jet.

[4] The power sources (45), (47) and (49) of the anode-torches (2), (3) and (4) are actuated. Since a DC voltage is applied between every cathode bar and first outer electrode, plasma arcs are turned on in the anode-torches. Then all plasma torches (1) to (4) hold pilot plasma arcs therein.

[5] Outer, transferable plasma arc will be built up. First, an outer, transferable arc plasma is produced between the cathode-torch (1) and anode-torch (2). The plasma arcs of the cathode-torch (1) and the anode-torch (2) are enlarged by increasing the power of the power sources (41) and (45). Two plasma flames come into contact and unite together.

[6] The switch (52) is turned on. The switch (46) is turned off. Negative poles of the DC power sources (41) and (45) are connected. Gas flow (25) in the anode-torch (2) is stopped. The inner plasma arc in the anode-torch (2) vanishes. The inner plasma in the cathode-torch (1) still stands. A new outer transferable arc plasma is produced between the first outer electrode (21) of the anode-torch (2) and the cathode bar (15) of the cathode-torch (1). In this case, what supplies power to the outer plasma arc is only the power source (45). The power source (41) gives electric power only the inner plasma arc of the cathode-torch (1). Otherwise, if the inner untransferable plasma of the cathode-torch (1) is extinguished by turning off the switch (42) as well as switch (46), the outer plasma can be kept as it is. However, keeping the inner plasma arc of the cathode-torch (1) is effective to stabilize the outer plasma arc between the cathode-torch (1) and the anode-torch (2). Accidental extinction will be avoided.

[7] The outer plasma arc between the cathode-torch (1) and the anode-torch (2) is strengthened by enhancing the power of the source (45). Then, another outer plasma will be yielded between the cathode-torch (1) and the next anode-torch (3). The power of the power source (47) is increased for enlarging the inner arc plasma flame formed between the cathode bar (29) and the first outer electrode (28) of the anode-torch (3). The inner plasma comes in contact with the established outer plasma flame. In the state, the switch (53) is turned on for connecting the negative pole of the power source (47) to the cathode bar (15) of the cathode-torch (1). The switch (48) is turned off. Flow of plasma formation gas (32) in the anode-torch (3) is stopped. The inner arc plasma in the anode-torch (3) is extinguished. Instead, another outer arc plasma is yielded between the first outer electrode (28) of the anode-torch (3) and the cathode bar (15) of the cathode-torch (1).

Then, the apparatus has three arc plasma flames, i.e. an outer plasma flame between the cathode-torch (1) and the anode-torch (2), another outer plasma flame between the cathode-torch (1) and the anode-torch (3) and an inner plasma flame between the cathode bar (15) and the second outer electrode (13) of the cathode-torch (1).

[8] Then, a third outer plasma will be formed between the anode-torch (4) and the cathode-torch (1). An inner plasma arc stands in the anode-torch (4). The power of the power source (49) is increased for enlarging the inner plasma of the anode-torch (4). Gradually the inner plasma flame grows and comes into contact with the already-established outer plasma arc flames between the anode-torches (2), (3) and the cathode-torch (1). The switch (51) is turned on. The cathode bar (15) of the cathode-torch (1) and the negative pole of the power source (49) are connected. The switch (50) is turned off. Flow of a plasma formation gas (39) in the anode-torch (4) is stopped. The inner plasma of the anode-torch (4) is extinguished. Instead, an outer plasma arc is generated between the first outer electrode (35) of the anode-torch (4) and the cathode bar (15) of the cathode torch (1).

[9] Three outer arc plasma flames are established between three anode-torches and one cathode-torch. These are outer transferable arc plasma formed between the first outer electrodes (21), (28), (35) of the anode-torches (2), (3), (4) and the cathode bar (15) of the cathode-torch (1).

[10] An inner arc plasma still remains between the cathode bar (15) and the second outer electrode (13) of the cathode torch (1). Thus, the inner plasma is put off by turning off the switch (42). Three outer arc plasma flames finally remain between the first outer electrodes (21), (28), (35) and the cathode bar (15) of the cathode-torch (1).

Operations [1] to [10] mentioned above enable us to produce a wide, outer arc plasma jet with a large sectional area between the cathode-torch and three anode-torches.

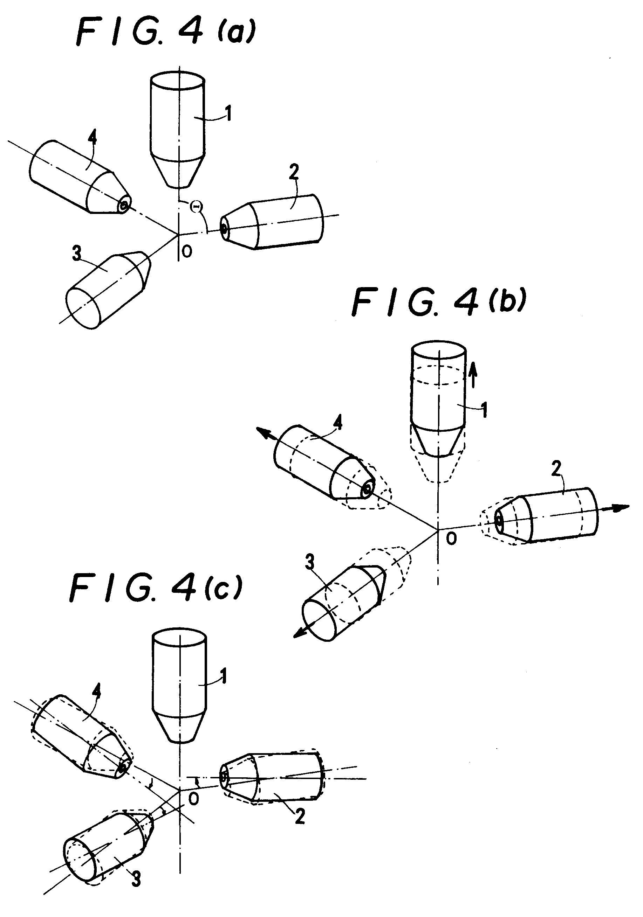

[11]This invention further enlarges the transferable, outer plasma arc jet by moving or rotating the plasma torches. Fig.4 demonstrates modes of displacement of the torches. Fig.4(a) shows an initial disposition of torches. Upward direction is denoted by z-axis, and two horizontal directions are denoted by x-axis and y-axis. A cathode-torch (1) is installed downward along z-axis. Central axes of anode-torches (2), (3) and (4) meet at the same point at a right angle to z-axis on their extensions. Thus, all anode-torches lie on the same plane vertical to z-axis ( $\Theta$ = 90 ° ). The neighboring anode-torches meet at a 120 degree angle on the extensions ( $\Phi$ = 120° ). Several modes of displacement will be explained.

(a) parallel transference of the cathode-torch (1) for receding from the crossing point O as shown in Fig.4(b).

(b) parallel transference of anode-torches in the directions of receding from the crossing point O as shown in Fig.4(b).

(c) Inclining the anode-torches for letting the extensions of the central lines of them deviate from the initial crossing point O as shown in Fig.4(c). Front ends incline downwards. Namely, initial directions of the anode-torches are represented by unit vectors,

$$( -\cos(2\pi i/3), -\sin(2\pi i/3 ), 0 ) \qquad i = 1, 2, 3 \qquad (13)$$

Final directions of the anode-torches are represented by unit vectors,

$$( -\cos(2\pi i/3 + \delta), -\sin(2\pi i/3 + \delta), -\epsilon ) \qquad i = 1, 2, 3 \qquad (14)$$

Where $\delta$ and $\epsilon$ are small amounts and are not necessarily the same for all the torches. Inclinations by $\delta$ and $\epsilon$ deviate the center lines of torches from point O.

(d) Inclination downwards of the anode-torches not shown figures.

Final state is expressed by the direction vectors.

$$( -\cos(2\pi i/3), -\sin( 2\pi i/3), - \epsilon ) \qquad (15)$$

Extensions of center lines of the anode-torches meet at a point below 0.

In these manners, the plasma formation area of outer plasma jets produced by the cathode-torch and anode-torches is widened by such dynamical operations.

A carbon-containing gas or a mixture gas of a carbon-containing gas and hydrogen gas is supplied to the confluences of plasma jets from the cathode-torch and the anode-torches by the nozzles (5), (6) and (7). Since operations (a) to (e) vary the plasma formation area, the positions of the confluences are also displaced. The nozzles are also displaced in accordance with the variations of the confluences in order to eject a carbon-containing gas to the present confluences at all times.

[12]A mixture gas of Ar and $H_2$ of Ar : $H_2$ = 1 : 1 in volume ratio is supplied as a plasma formation gas (19) in the passageway between the first and second outer electrodes (14) and (13).

[13]The pressure of the vacuum chamber (9) is reduced to about 200 Torr (2.67x10$^4$ Pa).

[14]The cooled susceptor (11) on which a molybdenum substrate body (12) had been fixed to ensure enough heat transmission has once lowered at a low point in the vacuum chamber (9). The cooled susceptor (11) is gradually raised up within the arc plasma jet flame (8') from the torches. A thermocouple ( not shown in figures ) is buried in the molybdenum substrate (12) for measuring the substrate body (12).

[15] The position of the cooled susceptor (11), power of plasma formation and pressure in the vacuum chamber (9) are adjusted to keep the substrate (12) in the plasma jet flame (8') and keep the surface of the substrate (12) at a temperature between about 700°C and about 1200°C.

[16] Next, methane gas ( $CH_4$ ) is introduced into the plasma jets from gas nozzles (5), (6) and (7) as a carbon-containing gas. Preferably the atomic ratio of carbon to hydrogen ( the number of carbon atoms to the number of hydrogen atoms ) in whole reaction gas should be less than about 10 %.

Addition of oxygen gas to a carbon-containing gas is also available. If oxygen is added to a carbon-containing gas to an atomic ratio of less than about 50 % of oxygen to carbon ( the number of oxygen to the number of carbon atoms ), it is allowable to raise the ratio of ( carbon atoms )/(hydrogen atoms ) up to about 20 %. Namely, the addition of oxygen gas enables a material gas to contain higher concentration of carbon by enhancing the ability of eliminating non-diamond carbon ingredients of synthesizing diamond by the action of oxygen.

If the ratio of carbon atoms increased over the limits in a carbon-containing gas, a deposited material on the substrate would contain plenty of non-diamond carbon ingredients. It is undesirable, since the deposited material is not pure diamond of high quality. In the disposition of the torches as shown in Fig.4, diamond is synthesized by the conditions shown in table 1 on a substrate of a diameter of 7.5 cm (3 inch).

Embodiment 1 enables us to synthesize diamond at more than about 100 $\mu$m/hr deposition speed on a 7.5 cm (3 inch) diameter substrate. The fluctuation of film thinness is less than about 10 %. Raman scattering spectroscopy certifies that the synthesized film is a diamond of good quality without inclusion of non-diamond ingredients. This invention allows us to synthesize a good diamond with a wide area at a high speed.

EP 0 522 842 B1

TABLE 1

| GAS COMPONENTS (L/min) | | GASES SUPPLIED TO TORCHES 1, 2, 3, 4 VIA GAS INLETS | | | | | | | | GASES SUPPLIED FROM NOZZLES 5,6,7 | | |
|---|---|---|---|---|---|---|---|---|---|---|---|---|
| | | Cathode-torch (1) | | Anode-torch (2) | | Anode-torch (3) | | Anode-torch (4) | | Nozzle No. | | |
| | | 16 | 17 | 25 | 26 | 32 | 33 | 39 | 40 | 5 | 6 | 7 |
| | Ar | 7.0 | 12.0 | 0 | 2.0 | 0 | 2.0 | 0 | 2.0 | 0 | 0 | 0 |
| | $H_2$ | 0 | 12.0 | 0 | 0 | 0 | 0 | 0 | 0 | 0 | 0 | 0 |
| | $CH_4$ | 0 | 0 | 0 | 0 | 0 | 0 | 0 | 0 | 0.15 | 0.15 | 0.15 |

| DC POWER OF POWER SOURCES (kW) | | SUPPLIED POWER TO TORCHES 1,2,3,4 | | | |
|---|---|---|---|---|---|
| | | Cathode-torch (1) | Anode-torch (2) | Anode-torch (3) | Anode-torch (4) |
| | No. | 41 | 45 | 47 | 49 |
| | kW | 0 | 12 | 12 | 12 |

| PRESSURE | 2 0 0 Torr (2.67 x 10$^4$ Pa) |
|---|---|
| TEMPERATURE OF SURFACE OF SUBSTRATE | 1 0 0 0 °C |

( Numbers correspond to reference numbers of torches, gas inlets, nozzles, or power sources in the figures )

[ EMBODIMENT 2 ]( M = 2, N = 2)

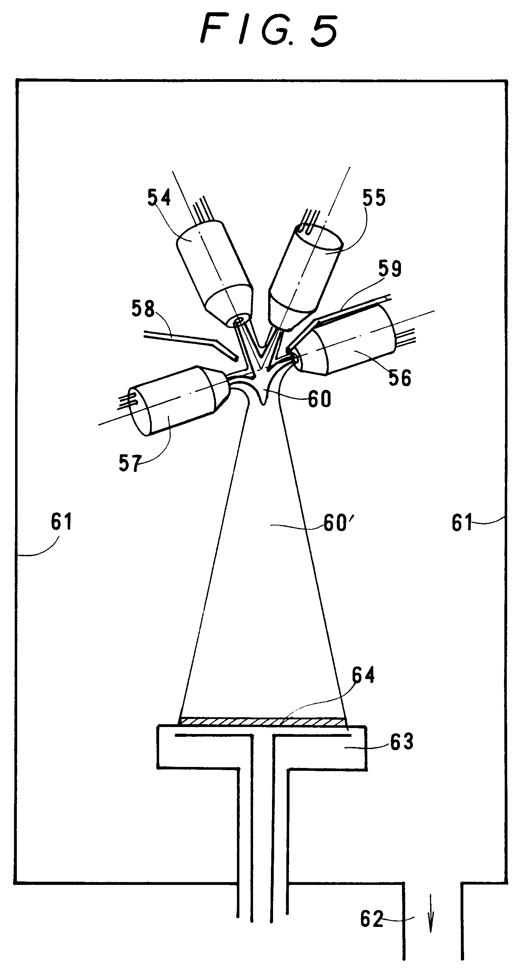

Fig.5 shows embodiment 2 which makes use of two cathode-torches and two anode-torches. Plasma torches (54), (55), (56) and (57) are individually able to form inner untransferable plasma jets by ejecting

15

plasma with discharge gases from gas outlets. In embodiment 2, the torches (54) and (55) will act as cathodes. Thus, the plasma torches (54) and (55) are called cathode-torches in short. On the contrary, the torches (56) and (57) act as anodes. The plasma torches (56) and (57) are called anode-torches. Cathode-torches are bigger than anode-torches in power in embodiment 2.

Gas nozzles (58) and (59) supply a carbon-containing gas or a mixture gas of a carbon-containing gas and hydrogen gas to the confluences of outer arc plasma jets from the cathode-torches (54) and (55) and from the anode-torches (56) and (57).

The plasma torches (54) to (57), gas nozzles (58) and (59) are installed in an upper space of the vacuum chamber (61) which can be made vacuous by a vacuum pump ( not shown in figures ) through a gas outlet (62). Diamond will be synthesized under a reduced pressure or atmospheric pressure. A cooled susceptor (63) on which a substrate body (64) is fixed is furnished at lower part of the vacuum chamber (61). Cooling water circulates in an inner space of the susceptor (63) for cooling and protecting it against hot plasma jets.

The cathode-torches are disposed with front ends facing downward along slanting lines which meet at a point 0. The anode-torches (56) and (57) are aligned along a horizontal line which is parallel to the surface of the substrate (64). A vertical plane including the cathode-torches (54) and (55) is perpendicular to a vertical plane including the anode-torches (56) and (57). The direction of the anode-torches (56) and (57) is assigned to x-axis. The distance between the center of cathode-torches and the crossing point O ( an origin of the coordinate ) is denoted by g. The positions of cathode-torches are simply expressed by

$$\text{cathode-torch (54)} \ ( \ 0, \ g \ \sin\Theta, \ g \ \cos\Theta \ ) \qquad (16)$$
$$\text{cathode-torch (55)} \ ( \ 0, \ -g \ \sin\Theta, \ g \ \cos\Theta \ ) \qquad (17)$$

The directions of the cathode-torches are designated by unit vectors ;

$$\text{cathode-torch (54)} \ ( \ 0, \ -\sin\Theta, \ -\cos\Theta \ ) \qquad (18)$$
$$\text{cathode-torch (55)} \ ( \ 0, \ \sin\Theta, \ -\cos\Theta \ ) \qquad (19)$$

Similarly the positions of the anode-torches (56) and (57) are given by,

$$\text{anode-torch (56)} \ ( \ h, \ 0, \ 0 \ ) \qquad (20)$$
$$\text{anode-torch (57)} \ ( \ -h, \ 0, \ 0 \ ) \qquad (21)$$

The directions of the anode-torches are expressed by vectors ;

$$\text{anode-torch (56)} \ ( \ -1, \ 0, \ 0 \ ) \qquad (22)$$
$$\text{anode-torch (57)} \ ( \ 1, \ 0, \ 0 \ ) \qquad (23)$$

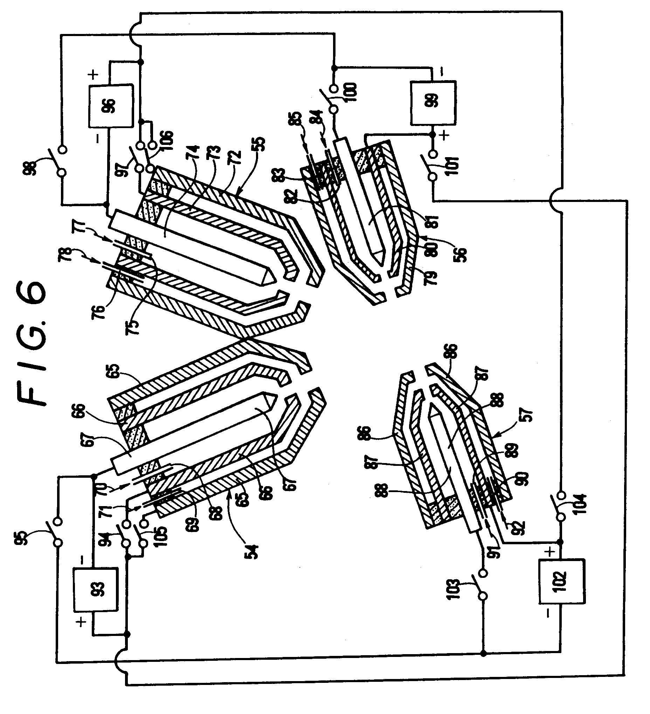

Fig.6 exhibits a sectional view of plasma torches and an electric circuit for connecting parts of torches and power sources Torches have the same structure irrespectively of anode-or cathode-torches. Connections of power sources are slightly different between cathode-torches and anode-torches. The cathode-torch (54) has coaxially a second outer electrode (65), a first outer electrode (66) and a cathode bar (67). The cathode bar (67) is a tungsten bar ( W ) which is cooled at the rear end. The outer electrodes (65) and (66) are anodes which have double walls for letting cooling water passing through the inner space. Three electrodes are electrically separated by an insulator end plate. A gas inlet (68) pierces the rear wall for supplying a plasma formation gas (70) in a passageway between the central cathode bar (67) and the first outer electrode (66). Another gas inlet (69) pierces the rear wall for supplying a plasma formation gas (71) into a passageway between the second outer electrode (65) and the first outer electrode (66).

Similarly the second cathode-torch (55) has a second outer electrode (72), a first outer electrode (73), a cathode bar (74) and gas inlets (75) and (76). Plasma formation gases (77) and (78) are introduced into passageways between the cathode bar (74) and outer electrodes (73) and (72) through the inlets (68) and (69).

The anode-torch (56) has a second outer electrode (79), a first outer electrode (80), a cathode bar (81), and gas inlets (82) and (83). Plasma formation gases (84) and (85) are introduced into passageways between the cathode bar (81) and the outer electrodes (80) and (79) through the gas inlets (82) and (83).

The anode-torch (57) has a second outer electrode (86), a first outer electrode (87), a cathode bar (88) and gas inlets (89) and (90). Plasma formation gases (91) and (92) are introduced into passageways between the electrodes through the gas inlets (89) and (90). All cathode bars are cooled at the rear ends.

All outer electrodes have double walls in which cooling water flows.

The first cathode-torch (54) is provided with a DC power source (93) which can superpose an RF voltage on a DC voltage. The negative pole of the power source (93) is connected to the cathode bar (67). Positive pole is connected via switches (94) and (105) to the first outer electrode (66) and the second outer electrode (65) respectively.

The second cathode-torch (55) is provided with a DC power source (96) which can superpose an RF voltage on a DC voltage. The negative pole of the power source (96) is connected to the cathode bar (74). The positive pole is connected via switches (97) and (106) to the first outer electrode (73) and the second outer electrode (71) respectively.

The first anode-torch (56) has a DC power source (99) which can superpose an RE voltage on a DC voltage. The negative pole of the power source (99) is via a switch (100) to the cathode bar (81). The positive pole is connected to the first outer electrode (80).

Similarly, the anode-torch (57) has a DC power source (102). The negative pole is connected to the cathode bar (88) via a switch (103). The positive pole is connected directly to the first outer electrode (87).

In order to form outer transferable arc plasma jets, the negative pole of power source (99) of the first anode-torch (56) is connected to the cathode bar (74) of the second cathode-torch (55) via a switch (98). The negative pole of the DC power source (102) of the second anode-torch (57) is connected to the cathode bar (67) of the first cathode-torch (54) via a switch (95). When outer arc plasma jets are formed between the cathode-torches and the anode-torches, the power source (99) supplies power to the plasma arc between the cathode-torch (55) and the anode-torch (56), and the power source (102) supplies power to the arc plasma between the cathode-torch (54) and the anode-torch (57).

Furthermore, the positive pole of the power source (96) is connected via a switch (104) to the first outer electrode (87) of the second anode-torch (57). Similarly, the positive pole of the power source (93) is connected via a switch (101) to the first outer electrode (80) of the first anode-torch (56). When outer arc plasma jets are formed between the cathode-torches and the anode-torches, the power source (96) supplies power to the arc plasma between the cathode-torch (55) and the anode-torch (57), and the power source (93) supplies power to the plasma arc between the cathode-torch (54) and the anode-torch (56).

At first, individual plasma torches (54), (55), (56) and (57) produce inner plasma arcs. In the step, an inert gas, e.g. Ar, He, Ne, or Kr is let flow in the passageway between the cathode bar and the first outer electrode to protect the cathode bar in all torches.

When outer plasma arcs are formed between the cathode-torches and the anode-torches, gases are let flow in the other passageway between the first outer electrode and the second outer electrode. A mixture gas of an inert gas and hydrogen gas is supplied to the cathode-torches (54) and (55). An inert gas is supplied to the anode-torches (56) and (57). In any cases, no carbon-containing gas flows in the torches.

Operations of the apparatus will be explained.

(1) A molybdenum ( Mo ) substrate body (64) of a diameter of 127 mm (5 inches) is tightly fixed on the cooled susceptor (63) in order to facilitate heat diffusion to cool enough the substrate body (64) against hot plasma jets. At first, the cooled susceptor (63) is lowered in the vacuum chamber (61) until the plasma jets are yielded and are stabilized. A thermocouple ( not shown in figures ) buried in the substrate body (64) can monitor the temperature of the substrate body (64).

(2) The vacuum chamber (61) is closed and made vacuous down to a pressure lower than about 0.133 Pa ($1\times10^{-3}$ Torr). Ar gas is supplied to all torches (54), (55), (56) and (57) through all gas inlets (68), (69), (75), (76), (82), (83), (89) and (90).

(3) Switches (94), (97), (100) and (103) are turned on. Switches (95), (98), (101), (104), (105) and (106) are left off. All power sources (93), (96), (99) and (102) are connected between the cathode bars (67), (74), (81) and (88) and the first outer electrodes (66), (73), (80) and (87) in individual torches.

(4) When the pressure of the vacuum chamber (61) attains to about $8.0\times10^{4}$ Pa (600 Torr), the power source (93) is actuated. An inner untransferable arc plasma jet is induced between the cathode bar (67) and the first outer electrode (68).

(5) Switch (105) is turned on. Switch (94) is turned off. The inner plasma arc is transferred to the inner space between the cathode bar (67) and the second outer electrode (65) of the first cathode-torch (54). The inner discharge is expanded in the torch (54).

(6) Similar operation is done to the second cathode-torch (55). The power source (96) is actuated. An inner plasma arc is induced between the cathode bar (74) and the first outer electrode (73). Switch (106) is turned on. Switch (97) is put off. The inner plasma jet is moved to between the cathode bar (74) and the second outer electrode (72). Namely, an inner plasma is put on in inner spaces at first and is moved to outer spaces. It is difficult to form an inner plasma arc therebetween without preparatory plasma. Then an inner plasma is put on at first between the nearer electrodes ; cathode bar and first electrode, then the plasma is transferred outer.

(7) Similarly an inner plasma arc is produced between the cathode bar (81) and the first outer electrode (80) in the anode-torch (56) by actuating the DC power source (99).

(8) Another inner plasma is induced similarly between the cathode bar (88) and the first outer electrode (87) of the anode-torch (57) by actuating the power source (102). Thus, all four plasma torches (54), (55), (56) and (57) keep individual inner plasma jets which are now called pilot arcs.

(9) Next outer plasma jets will be formed between anode-torches and cathode-torches in turns. First an transferable outer arc plasma will be formed between the anode-torch (57) and the cathode-torch (54). Power of the DC power sources (93) and (102) is gradually raised to enlarge two arc plasma jets of the torches (54) and (57). Then, two plasma jets come into contact. Switch (95) is turned on. Switch (103) is turned off. Introduction of plasma formation gas (91) into the anode-torch (57) is stopped. At the step, the cathode-torch (54) has an inner plasma arc between the cathode bar (67) and the second outer electrode (65) and an outer transferable plasma jet between the cathode bar (67) of the torch (54) and the first electrode (87) of the second anode-torch (57). The inner plasma arc in the anode-torch (57) has been extinguished.

(10) A second outer transferable plasma arc will be formed in a similar manner between the cathode-torch (55) and the anode-torch (56). Power of the DC power sources (96) and (99) is gradually raised in order to enlarge the arc plasma in the torches (55) and (56). Both plasma jets come into contact with each other. Switch (98) is turned on. Switch (100) is turned off. Injection of plasma formation gas (84) into the anode-torch (56) is stopped. In this state, the inner arc plasma remains in the cathode-torch (55). Besides it, a second outer transferable arc plasma jet is produced between the cathode bar (74) of the cathode-torch (55) and the first electrode (80) of the anode-torch (56). The inner plasma in the anode-torch (56) has been already extinguished.

(11) Switch (101) is turned on. Switch (105) is turned off. these operations produce a third outer arc plasma jet between the cathode bar (67) of the first cathode-torch (54) and the first outer electrode (80) of the first anode-torch (56). Instead, the inner arc plasma of the cathode-torch (54) has vanished. Accordingly in this step three outer plasma jets exist. Two outer plasma jets span the cathode bar (67) of the cathode-torch (54) and the first outer electrodes (80) and (87) of the anode-torches (56) and (57). The other one spans the cathode bar (74) of the torch (55) and the first outer electrode (80) of the anode-torch (56).

(12) Switch (104) is turned on. Switch (106) is turned off. These operations connect the cathode bar (74) of the second cathode-torch (55) to the first outer electrode (87) of the anode-torch (57). A fourth outer transferable arc plasma jet is produced between the cathode bar (74) of the cathode-torch (55) and the first outer electrode (87) of the anode-torch (57). The inner arc plasma of the cathode-torch (57) has vanished.

Therefore, four outer arc plasma jets are formed between two cathode-torches and two anode-torches. In the state, initially-induced inner plasma arcs have all been extinguished. Inner plasma is required for inducing outer discharge between torches. Once outer discharge is put on, the inner plasma becomes unnecessary. Thus, the inner arc plasma shall be turned off, when all outer plasma jets have been established. During these operations the power sources must be adjusted so as to keep a good balance of outer plasma jets held by the currents supplied by the power sources and to stabilize the state of discharge.

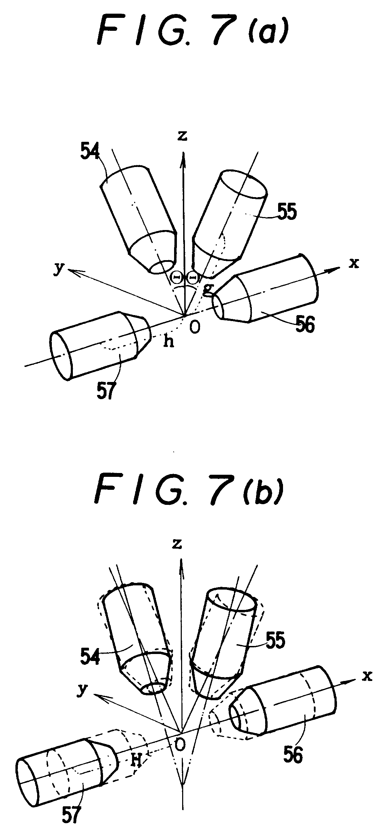

(13) These operations form a wide plasma jet by associating four outer plasma jets into one plasma jet by the geometry of the torches as shown in Fig.5. This invention further enlarges the associated plasma jet. Some of torches or all of torches will be moved in parallel or rotated in the directions for enhancing the plasma formation area as shown in Fig.7. Fig.7(a) is an initial state. As explained before, extensions of center lines of four torches meet at a point O ( an origin of coordinate ). Two cathode-torches are arranged at symmetric spots on yz-plane to z-axis. Two anode-torches lie along x-axis face to face. Fig.7(b) demonstrates modes of movements or rotations of torches.

(I) Cathode-torches are rotated around lines parallel with x-axis with center lines meeting at a point on z-axis below O. In the variation, the unit vectors signifying the directions of the cathode-torches (54) and (55) are expressed by

$$54 \ ( \ 0, \ -\sin( \ \Theta - \Delta), \ -\cos(\Theta - \Delta) \ ) \qquad (24)$$
$$55 \ ( \ 0, \ \sin( \ \Theta - \Delta), \ -\cos(\Theta - \Delta \ ) \ ) \qquad (25)$$

where $\Delta$ is a positive parameter. The cross point of center lines of torches lies on z-axis below O. The z-coordinate is

$$z = g \cos\Theta - g \cos ( \Theta - \Delta ) \qquad (26)$$

(II) Anode-torches are displaced along x-axis in the reciprocal directions for receding each other. Instead of Eqs.(20) and (21), positions of anode-torches are denoted by

$$56 ( H, 0, 0 ) \qquad (27)$$
$$57 ( -H, 0, 0 ) \qquad (28)$$

Where $H > h$.

(III) Cathode-torches recede from O along the center lines. This mode is not shown in figures. By a parameter G ( $G > g$ ), the positions of the torches are written as

$$54 ( 0, G \sin\Theta, G \cos\Theta ) \qquad (29)$$
$$55 ( 0, -G \sin\Theta, G \cos\Theta ) \qquad (30)$$

(IV) Anode-torches are rotated around lines parallel with z-axis as to veer the center lines from point O. Instead of (22) and (23), unit vectors of the torches are represented by

$$56 ( - \cos \epsilon, \sin \epsilon, 0 ) \qquad (31)$$
$$57 ( \cos \epsilon, -\sin \epsilon , 0 ) \qquad (32)$$

Where $\epsilon$ is an arbitrary parameter. This mode is not shown in Fig.7. One mode or two modes of movements and rotations of torches enhance the plasma formation area to great extent. This invention conspicuously features such an enlargement of plasma area.

(14) After the plasma formation area of the associated plasma jet has been enlarged by the displacement or rotations of torches, gas nozzles (58) and (59) must be also moved or rotated in order to supply a carbon-containing gas to confluences or other optimum points of the arc plasma jet. Variation of confluences of jets themselves induced by the displacement of torches requires readjustment of the nozzles.

(15) A mixture gas of Ar : $H_2$ = 1 : 1 is introduced into the passageways between the first and second outer electrodes through gas inlets (69) and (76) of cathode torches (54) and (55). Other passageways between the cathode bars and the first outer electrodes have been supplied with only Ar gas since step (2) through gas inlets (68) and (77). Ar gas plays a role of protecting cathode bars (67) and (74) besides keeping plasma arcs. On the contrary, anode-torches (56) and (57) are supplied only with Ar gas into the passageways between the first and second outer electrodes through the gas inlets (83) and (90). Similarly, Ar gas contributes to protecting the first outer electrodes (80) and (87) besides keeping plasma arcs.

(16) The pressure of the vacuum chamber (61) is reduced to about 200 Torr. The outer plasma jets are stably kept between torches. The cooled susceptor which has been lowered at a lower point is raised at a higher point till the substrate body comes into the plasma jet flame (60'). The height of the cooled susceptor (63), power of plasma formation, pressure of reaction shall be adjusted in order to keep the temperature of the surface of the substrate body (64) from about 700°C to about 1200°C by monitoring the output of the thermocouple.

(17) Methane gas as a carbon-containing gas is spurted from gas nozzles (58) and (59) to the arc plasma jets.

According to these operations, diamond is synthesized on a molybdenum substrate of a diameter of 127 mm (5 inches) under the conditions exhibited in TABLE 2. This invention enables us to synthesize a diamond film of 127 mm (5 inches) in diameter on the Mo substrate at a deposition speed higher than about 100μm/hr. The fluctuation of film thickness is less than about 15 % in spite of such width of 127 mm (5 inches). The diamond is superior in the uniformity of thickness. Raman scattering spectroscopy certifies that the diamond contains little impurities ; non-diamond carbon ingredients. Embodiment 2 allows us to fabricate a wide diamond film of good quality at a high speed more than about 100 μm/hr.

TABLE 2

| GAS COMPONENTS (L/min) | | GAS SUPPLIED TO TORCHES 54, 55, 56, 57 VIA GAS INLETS | | | | | | | | GASES SUPPLIED FROM NOZZLES 58,59 | |
|---|---|---|---|---|---|---|---|---|---|---|---|
| | | Cathode-torch (54) | | Cathode-torch (55) | | Anode-torch (56) | | Anode-torch (57) | | Nozzle No. | |
| | | 70 | 71 | 77 | 78 | 84 | 85 | 91 | 92 | 58 | 59 |
| | Ar | 5.0 | 10.0 | 5.0 | 10.0 | 0 | 3.0 | 0 | 3.0 | 0 | 0 |
| | $H_2$ | 0 | 10.0 | 0 | 10.0 | 0 | 0 | 0 | 0 | 0 | 0 |
| | $CH_4$ | 0 | 0 | 0 | 0 | 0 | 0 | 0 | 0 | 0.4 | 0.4 |

| DC POWER OF POWER SOURCES (kW) | | SUPPLIED POWER OF TORCHES 54,55,56,57 | | | |
|---|---|---|---|---|---|
| | | Cathode-torch (54) | Cathode-torch (55) | Anode-torch (56) | Anode-torch (57) |
| | No. | 93 | 96 | 99 | 102 |
| | kW | 15 | 15 | 15 | 15 |

| PRESSURE | 1 5 0 Torr (2.0 x 10$^4$ Pa) |
|---|---|
| TEMPERATURE OF SURFACE OF SUBSTRATE | 1 0 0 0 °C |

Claims

1. A method for synthesizing diamond by decomposing and activating a material gas by DC plasma generated by a DC voltage applied between an anode and a cathode of a plasma torch and by spraying activated plasma on a substrate body, comprising the steps of disposing more than three plasma torches such that an extension of the central axis of each torch meets the extension of the other

20

torches at a point and such that said axes are not aligned along a straight line and are not parallel to each other, the plasma torch having anodes and cathodes in coaxial relation and gas passageways between the anodes and cathodes, the plasma torch being capable of forming an untransferable, inner DC arc plasma jet, at least one of the plasma torches acting as a cathode (a cathode-torch), the other plasma torches acting as anodes (anode-torches), letting an insert gas or a mixture of an inert gas and hydrogen gas flow in passageways between the cathode and the anode of the individual plasma torches, applying a voltage between the anode and the cathode of the individual plasma torches, yielding untransferable, inner DC plasma jets, stopping the inner discharge in the individual torches, associating plural transferable, outer plasma jets together, forming a wide, uniform associated plasma jet, spurting a carbon-containing gas or mixture of hydrogen gas and a carbon-containing gas towards the confluences of the plasma jets, and spraying the plasma jet on a substrate body positioned in a stream of the plasma jets, and depositing diamond synthesized in a vapor phase reaction on the substrate body.

2. A method for synthesizing diamond by decomposing and activating a material gas by DC plasma generated by a DC voltage applied between an anode and a cathode of a plasma torch and by spraying activated plasma on a substrate body, comprising the steps of disposing more than three plasma torches such that an extension of a central axis of each torch meets the extensions of the other at a point and such that said axes are not aligned along a straight line and are not parallel to each other, the plasma torch having anodes and cathodes in coaxial relation, and gas passageways between the anodes and cathodes, the plasma torch being capable of forming an untransferable, inner DC arc plasma jet, at least one of the plasma torches acting as a cathode (a cathode-torch), the other plasma torches acting as anodes (anode-torches), letting an inert gas or a mixture of an inert gas and hydrogen gas flow in passageways between the cathode and the anode of the individual plasma torches, applying a voltage between the anode and the cathode of the individual plasma torches, yielding untransferable, inner DC plasma jets, stopping the inner discharge in the individual torches, associating plural transferable, outer plasma jets together, forming a wide, uniform associated plasma jet, spurting a carbon-containing gas or a mixture of hydrogen gas and a carbon-containing gas towards the associated plasma jet flame, and spraying the plasma jet on a substrate body positioned in a stream of the plasma jets, and depositing diamond synthesized in a vapor phase reaction on the substrate body.

3. A method as claimed in claim (1) or claim (2), wherein a carbon-containing gas or a mixture of hydrogen gas and a carbon-containing gas is spurted to confluences of the plasma jets by nozzles which can be moved or inclined according to change of places of confluences of the plasma jets.

4. A method as claimed in claim (1), claim (2) or claim (3), wherein individual plasma torches can be moved in parallel transference or can be rotated in angular direction, the anode-torches are arranged with their central axes meeting at a point on an extension of the cathode-torch before turning on outer plasma arcs between the cathode-torch and the anode-torches, the anode-torches and the cathode-torch are displacing in the direction in which they recede farther from the confluences or are rotated in angular directions in which the extensions of central axes of the torches deviate from the former confluences in order to enlarge the associated plasma jet.

5. A method as claimed in claim (1), claim (2) claim (3) or claim (4), wherein more than two anode-torches are installed to one cathode-torch, transferable, outer arc plasma jets can be formed between the cathode-torch and the plural anode-torches, an extension of the cathode-torch meets at a right angle to a surface of the substrate body, and plural anode-torches are disposed at places of rotational symmetry around the extension of the cathode-torch.

6. A method as claimed in claim (1), claim (2) claim (3) or claim (4), wherein more than two cathode-torches are installed to one anode-torch, transferable, outer arc plasma jets can be formed between the cathode-torches and the anode-torch, an extension of the anode-torch meets at right angle to a surface of the substrate body, and plural cathode-torches are disposed at places of rotational symmetry around the extension of the anode-torch.

7. A method as claimed in claim 1, claim 2, claim 3, claim 4 or claim 6, wherein after a transferable, outer plasma jet is formed between the cathode-torches and the anode-torches, the transferable plasma jets are enlarged by increasing distances between the cathode-torches or distances between the anode-torches or inclining the cathode-torches or anode-torches.

8. An apparatus for synthesizing diamond by dissolving and activating a material gas by DC plasma generated by a DC voltage applied between an anode and a cathode of a plasma torch and by spraying activated plasma on a substrate body, comprising a vacuum chamber, a vacuum pump for creating a vacuum in the vacuum chamber, a supporter for holding the substrate body in the vacuum chamber, a plurality of plasma torches located in the vacuum chamber for producing a DC plasma jet, each plasma torch having a cathode bar and anodes mounted coaxially around a central axis, the plasma torches being arranged in a conical arrangement, such that an extension of the central axes of each torch meets the extension of the other torches at a point, a plurality of nozzles for spurting a carbon-containing gas into the DC plasma jets created by the plasma torches, power sources for supplying a DC voltage or a DC voltage superposed with an RF voltage between cathodes and anodes of the plasma torches, electrical connections for connecting plural plasma torches to the power sources, plural switches provided in the electrical connections for turning on or turning off the voltage supply to the cathodes or anodes of the torches, the arrangement being such that, in use, some of the plasma torches act as cathodes (cathode-torches), and the other of the plasma torches acting as anodes (anode-torches), the plasma torches being capable of forming individual arc plasma columns in them in response to application of a voltage between the cathode and the anode, and the anode-torches and the cathode-torches being capable of forming a wide, associated plasma arc jet in response to operation of the switches.

9. An apparatus for synthesizing diamond by dissolving and activating a material gas by DC plasma generated by a DC voltage applied between an anode and a cathode of a plasma torch and spraying activated plasma on a substrate body, comprising a vacuum chamber, a vacuum pump for creating a vacuum in the vacuum chamber, a supporter for holding the substrate body in the vacuum chamber, a plurality of plasma torches located in the vacuum chamber for producing a DC plasma jet, each plasma torch having a cathode bar and anodes mounted coaxially around a central axis, the plasma torches being arranged in a conical arrangement such that an extension of each central axes of each-torch meets the extensions of the other torches at a point, a plurality of nozzles for spurting a carbon-containing gas into the DC plasma jets created by the plasma torches, power sources for supplying a DC voltage or a DC voltage superposed with an RF voltage between cathodes and anodes of the plasm torches, electrical connections for connecting plural plasma torches to the power sources, plural switches provided in the electrical connections for turning on or turning off the voltage supply to the cathodes or anodes of the torches, the arrangement being such that, in use, some of the plasma torches act as cathodes (cathode-torches), and the other of the plasma torches acting as anodes (anode-torches), the plasma torches being capable of forming individual arc plasma columns in them in response to the application of a voltage between the cathode and the anode, the anode-torches and the cathode-torches being capable of forming a wide, associated plasma arc jet by operating the switches for applying voltage between the anode-torches as anodes and the cathode-torches as cathodes, and the plasma torches being capable of being displaced or rotated in order to change an area of the associated plasma arc jet.

10. An apparatus as claimed in claim (8) or (9), wherein the cathode-torches are arranged at positions rotationally symmetric with regard to a normal drawn from a center of the substrate body with a small inclination angle less than 45° between the normal and axial lines of the cathode-torches, the anode-torches are arranged at positions rotationally symmetric with regard to the normal with a big inclination angle between 45° and 90° between the normal and axial lines of the anode-torches, the anode-torches and the cathode-torches are disposed by turn in angular direction, transferable, outer arc plasma jets are formed between every anode-torch and neighboring cathode-torches.

11. An apparatus as claimed in claim (8) or (9), wherein one cathode-torch is aligned along a normal drawn from a center of the substrate body, plural anode-torches are arranged at positions rotationally symmetric with regard to the normal with an inclination angle between 60° and 120°, transferable, outer arc plasma jets are formed between the cathode-torch and all the anode-torches.

**Patentansprüche**

1. Verfahren zur Synthese von Diamant durch Zersetzung und Aktivierung eines Materialgases durch ein Gleichstromplasma, das durch eine zwischen eine Anode und eine Kathode eines Plasmabrenners angelegte Gleichspannung erzeugt wird, und durch Aufsprühen von aktiviertem Plasma auf einen Substratkörper, mit den Schritten: Anordnen von mehr als drei Plasmabrennern derart, daß eine Verlängerung der Mittenachse jedes Brenners die Verlängerung der anderen Brenner an einem Punkt trifft und daß die Achsen nicht längs einer geraden Linie ausgerichtet und nicht parallel zueinander sind, wobei der Plasmabrenner eine Anode und eine Kathode in koaxialer Beziehung und Gasdurchlässe zwischen der Anode und Kathode hat, wobei der Plasmabrenner zur Bildung eines nichttransferablen, inneren Gleichstrombogen-Plasmastrahls fähig ist und mindestens einer der Plasmabrenner als eine Kathode (ein Kathodenbrenner) wirkt und die anderen Plasmabrenner als Anoden (Anodenbrenner) wirken, Strömenlassen eines Inertgases oder eines Inertgas- und Wasserstoffgas-Gemisches in Durchlässen zwischen der Kathode und der Anode der einzelnen Plasmabrenner, Anlegen einer Spannung zwischen der Anode und der Kathode der einzelnen Plasmabrenner, Erzeugen nicht-transferabler, innerer Gleichstrom-Plasastrahlen, Beenden der inneren Entladung in den einzelnen Brennern, Verbinden mehrerer transferabler, äußerer Plasmastrahlen miteinander, Bilden eines breiten, gleichmäßig verbundenen Plasmastrahls, Ausstoßen eines kohlenstoffhaltigen Gases oder Gemisches aus Wasserstoffgas und einem kohlenstoffhaltigen Gas zu den Zusammenflüssen der Plasmastrahlen hin und Aufsprühen des Plasmastrahls auf einen Substratkörper, der in einem Strom der Plasmastrahlen angeordnet ist, und Abscheiden des in einer Gasphasenreaktion synthetisierten Diamants auf den Substratkörper.

2. Verfahren zur Synthese von Diamant durch Zersetzung und Aktivierung eines Materialgases durch ein Gleichstromplasma, das durch eine zwischen eine Anode und eine Kathode eines Plasmabrenners angelegte Gleichspannung erzeugt wird, und durch Aufsprühen von aktiviertem Plasma auf einen Substratkörper, mit den Schritten: Anordnen von mehr als drei Plasmabrennern derart, daß eine Verlängerung der Mittenachse jedes Brenners die Verlängerung der anderen Brenner an einem Punkt trifft und daß die Achsen nicht längs einer geraden Linie ausgerichtet und nicht parallel zueinander sind, wobei der Plasmabrenner eine Anode und eine Kathode in koaxialer Beziehung und Gasdurchlässe zwischen der Anode und Kathode hat, wobei der Plasmabrenner zur Bildung eines nicht-transferablen, inneren Gleichstrombogen-Plasmastrahls fähig ist und mindestens einer der Plasmabrenner als eine Kathode (ein Kathodenbrenner) wirkt und die anderen Plasmabrenner als Anoden (Anodenbrenner) wirken, Strömenlassen eines Inertgases oder eines Inertgas- und Wasserstoffgas-Gemisches in Durchlässen zwischen der Kathode und der Anode der einzelnen Plasmabrenner, Anlegen einer Spannung zwischen der Anode und der Kathode der einzelnen Plasmabrenner, Erzeugen nicht-transferabler, innerer Gleichstrom-Plasmastrahlen, Beenden der inneren Entladung in den einzelnen Brennern, Verbinden mehrerer transferabler, äußerer Plasmastrahlen miteinander, Bilden eines breiten, gleichmäßig verbundenen Plasmastrahls, Ausstoßen eines kohlenstoffhaltigen Gases oder einer Mischung aus Wasserstoffgas und einem kohlenstoffhaltigen Gas zur verbundenen Plasmastrahlflamme, und Aufsprühen des Plasmastrahls auf einen Substratkörper, der in einem Strom der Plasmastrahlen angeordnet ist, und Abscheiden des in einer Gasphasenreaktion synthetisierten Diamants auf den Substratkörper.

3. Verfahren nach Anspruch 1 oder Anspruch 2, wobei ein kohlenstoffhaltiges Gas oder ein Gemisch aus Wasserstoffgas und einem kohlenstoffhaltigen Gas zu Zusammenflüssen der Plasmastrahlen hin durch Düsen ausgestoßen wird, die entsprechend Ortsänderungen der Zusammenflüsse der Plasmastrahlen bewegt oder geneigt werden können.

4. Verfahren nach Anspruch 1, Anspruch 2 oder Anspruch 3, wobei einzelne Plasmabrenner durch Parallelverschiebung bewegt oder in der Winkelausrichtung gedreht werden können, die Anodenbrenner mit ihren Mittenachsen so angeordnet sind, daß sie an einem Punkt auf eine Verlängerung des Kathodenbrenners treffen, bevor äußere Plasmabögen zwischen dem Kathodenbrenner und den Anodenbrennern eingeschaltet werden, die Anodenbrenner und der Kathodenbrenner in die Richtung verschoben werden, in der sie weiter von den Zusammenflüssen entfernt sind, oder daß sie in Winkelrichtungen gedreht werden, in denen die Verlängerungen der Mittenachsen der Brenner von den früheren Zusammenflüssen abweichen, um den verbundenen Plasmastrahl zu vergrößern.

5. Verfahren nach Anspruch 1, Anspruch 2, Anspruch 3 oder Anspruch 4, wobei mehr als zwei Anodenbrenner bei einem Kathodenbrenner installiert sind, transferable, äußere Bogenplasmastrahlen zwischen dem Kathodenbrenner und den mehreren Anodenbrennern gebildet werden können, eine Verlängerung des Kathodenbrenners in einem rechten Winkel auf die Oberfläche des Substratkörpers auftrifft und mehrere Anodenbrenner an Orten rotationssymmetrisch um die Verlängerung des Kathodenbrenners angeordnet sind.

6. Verfahren nach Anspruch 1, Anspruch 2, Anspruch 3 oder Anspruch 4, wobei mehr als zwei Kathodenbrenner bei einem Anodenbrenner angeordnet sind, transferable äußere Plasmastrahlen zwischen den Kathodenbrennern und dem Anodenbrenner gebildet werden können, eine Verlängerung des Anodenbrenners in einem rechten Winkel auf die Oberfläche des Substratkörpers auftrifft und mehrere Kathodenbrenner an Orten rotationssymmetrisch um die Verlängerung des Anodenbrenners angeordnet sind.

7. Verfahren, nach Anspruch 1, Anspruch 2, Anspruch 3, Anspruch 4 oder Anspruch 6, wobei, nachdem ein transferabler äußerer Plasmastrahl zwischen den Kathodenbrennern und dem Anodenbrenner gebildet ist, die transferablen Plasmastrahlen durch Erhöhung der Abstände zwischen den Kathodenbrennern oder der Abstände zwischen den Anodenbrennern oder Neigen der Kathodenbrenner oder Neigen der Kathodenbrenner oder der Anodenbrenner vergrößert werden.

8. Vorrichtung zur Synthese von Diamant durch Auflösen und Aktivieren eines Materialgases durch ein Gleichstromplasma, das durch eine zwischen eine Anode und eine Kathode eines Plasmabrenners angelegte Gleichspannung erzeugt wird, und durch Aufsprühen von aktiviertem Plasma auf einen Substratkörper, mit einer Vakuumkammer, einer Vakuumpumpe zum Erzeugen eines Vakuums in der Vakuumkammer, einem Träger zum Halten des Substratkörpers in der Vakuumkammer, einer Mehrzahl von Plasmabrennern, die in der Vakuumkammer angeordnet sind, zur Erzeugung eines Gleichstrom-Plasmastrahls, wobei jeder Plasmabrenner einen Kathodenstab und koaxial um eine Mittenachse angebrachte Anoden hat und die Plasmabrenner in einer konischen Anordnung derart angeordnet sind, daß eine Verlängerung der Mittenachsen jedes Brenners die Verlängerung der anderen Brenner in einem Punkt trifft, einer Mehrzahl von Düsen zum Ausstoßen eines kohlenstoffhaltigen Gases in die durch die Plasmabrenner erzeugten Gleichstrom-Plasmastrahlen, Stromversorgungsquellen zum Liefern einer Gleichspannung oder einer Gleichspannung mit überlagerter HF-Spannung zwischen Kathoden und Anoden der Plasmabrenner, elektrischen Verbindungen zum Verbinden der mehreren Plasmabrenner mit den Stromversorgungsquellen, mehreren in den elektrischen Verbindungen angeordneten Schaltern zum Einschalten oder Ausschalten der Spannungsversorgung der Kathoden oder Anoden der Brenner, wobei die Anordnung derart ist, daß im Gebrauch einige der Plasmabrenner als Kathoden (Kathodenbrenner) und die anderen der Plasmabrenner als Anoden (Anodenbrenner) wirken, wobei die Plasmabrenner zur Bildung einzelner Bogen-Plasmasäulen darin in Reaktion auf das Anlegen einer Spannung zwischen der Kathode und der Anode fähig sind und die Anodenbrenner und die Kathodenbrenner zur Erzeugung eines breiten, verbundenen Plasmabogenstrahls in Reaktion auf die Betätigung der Schalter fähig sind.

9. Vorrichtung zur Synthese von Diamant durch Auflösen und Aktivieren eines Materialgases durch ein Gleichstromplasma, das durch eine zwischen eine Anode und eine Kathode eines Plasmabrenners angelegte Gleichspannung erzeugt wird, und durch Aufsprühen von aktiviertem Plasma auf einen Substratkörper, mit einer Vakuumkammer, einer Vakuumpumpe zum Erzeugen eines Vakuums in der Vakuumkammer, einem Träger zum Halten des Substratkörpers in der Vakuumkammer, einer Mehrzahl von Plasmabrennern, die in der Vakuumkammer angeordnet sind, zur Erzeugung eines Gleichstrom-Plasmastrahls, wobei jeder Plasmabrenner einen Kathodenstab und koaxial um eine Mittenachse angebrachte Anoden hat und die Plasmabrenner in einer konischen Anordnung derart angeordnet sind, daß eine Verlängerung der Mittenachsen jedes Brenners die Verlängerung der anderen Brenner in einem Punkt trifft, einer Mehrzahl von Düsen zum Ausstoßen eines kohlenstoffhaltigen Gases in die durch die Plasmabrenner erzeugten Gleichstrom-Plasmastrahlen, Stromversorgungsquellen zum Liefern einer Gleichspannung oder einer Gleichspannung mit überlagerter HF-Spannung zwischen Kathoden und Anoden der Plasmabrenner, elektrischen Verbindungen zum Verbinden der mehreren Plasmabrenner mit den Stromversorgungsquellen, mehreren in den elektrischen Verbindungen angeordneten Schaltern zum Einschalten oder Ausschalten der Spannungsversorgung der Kathoden oder Anoden der Brenner, wobei die Anordnung derart ist, daß im Gebrauch einige der Plasmabrenner als Kathoden (Kathodenbrenner) und die anderen der Plasmabrenner als Anoden (Anodenbrenner) wirken, wobei die Plasmabrenner zur Bildung einzelner Bogen-Plasmasäulen darin in Reaktion auf das Anlegen einer Spannung zwischen der Kathode und der Anode fähig sind und die Anodenbrenner und die Kathodenbrenner zur Erzeugung eines breiten, verbundenen Plasmabogenstrahls durch Betätigung der Schalter zum Anlegen einer Spannung zwischen den Anodenbrennern als Anoden und den Kathodenbrennern als Kathoden, wobei die Plasmabrenner verschieb- oder drehbar sind, um eine Fläche des verbundenen Plasmabogenstrahls zu verändern.

10. Vorrichtung nach Anspruch 8 oder 9, wobei die Kathodenbrenner in Positionen rotationssymmetrisch bezüglich einer Normalen, die in einem Zentrum des Substratkörpers errichtet ist, mit einem kleinen Neigungswinkel unter 45° zwischen der Normalen und Achsenlinien der Kathodenbrenner angeordnet sind, die Anodenbrenner in Positionen rotationssymmetrisch bezüglich der Normalen mit einem großen Neigungswinkel zwischen 45° und 90° zwischen der Normalen und Achsenlinien der Anodenbrenner angeordnet sind, die Anodenbrenner und die Kathodenbrenner in Unfangsrichtung aufeinanderfolgend angeordnet sind und transferable äußere Bogenplasmastrahlen zwischen jedem Anodenbrenner und benachbarten Kathodenbrennern gebildet sind.

11. Vorrichtung nach Anspruch 8 oder 9, wobei ein Kathodenbrenner längs einer in einem Zentrum auf dem Substratkörper errichteten Normalen ausgerichtet ist, mehrere Anodenbrenner in Positionen rotationssymmetrisch bezüglich der Normalen mit einem Neigungswinkel zwischen 60° und 120° angeordnet sind und transferable äußere Bogenplasmastrahlen zwischen dem Kathodenbrenner und allen Anodenbrennern gebildet sind.

**Revendications**

1. Procédé pour synthétiser le diamant en décomposant et activant un gaz de matière par un plasma à courant continu produit par une tension continue appliquée entre une anode et une cathode d'une torche à plasma et en pulvérisant le plasma activé sur un corps formant substrat, le procédé comprenant les étapes consistant à disposer plus de trois torches à plasma de telle manière que le prolongement de l'axe central de chaque torche rencontre le prolongement des autres torches en un point, et de telle manière que lesdits axes ne soient pas alignés le long d'une ligne droite et ne soient pas parallèles les uns aux autres, les torches à plasma ayant des anodes et des cathodes en relation coaxiale et des passages de gaz entre les anodes et les cathodes, la torche à plasma étant apte à former un jet intérieur non transférable de plasma d'arc à courant continu, au moins une des torches à plasma agissant comme une cathode (torche cathode), les autres torches à plasma agissant comme des anodes (torches anodes), faire circuler un gaz inerte ou un mélange d'un gaz inerte et d'hydrogène gazeux dans des passages compris entre la cathode et l'anode des torches à plasma individuelles, appliquer une tension entre l'anode et la cathode des torches à plasma individuelles, produire des jets intérieurs non transférables de plasma à courant continu, arrêter la décharge intérieure dans les torches individuelles, associer ensemble plusieurs jets de plasma extérieurs transférables, former un jet de plasma associé uniforme et large, projeter un gaz contenant du carbone ou un mélange d'hydrogène gazeux et d'un gaz contenant du carbone vers les confluences des jets de plasma, et pulvériser le jet de plasma sur un corps formant substrat disposé dans un courant des jets de plasma, et déposer du diamant synthétisé dans une réaction en phase vapeur sur le corps formant substrat.

2. Procédé pour synthétiser le diamant en décomposant et activant un gaz de matière par un plasma à courant continu produit par une tension continue appliquée entre une anode et une cathode d'une torche à plasma et en pulvérisant le plasma activé sur un corps formant substrat, le procédé comprenant les étapes consistant à disposer plus de trois torches à plasma de telle manière qu'un prolongement d'un axe central de chaque torche rencontre les prolongements des autres torches en un point, et de telle manière que lesdits axes ne soient pas alignés le long d'une ligne droite et ne soient pas parallèles les uns aux autres, les torches à plasma ayant des anodes et des cathodes en relation coaxiale et des passages de gaz entre les anodes et les cathodes, les torches à plasma étant aptes à former un jet intérieur de plasma d'arc à courant continu, au moins une des torches à plasma agissant comme une cathode (torche cathode), les autres torches à plasma agissant comme des anodes (torches anodes), faire circuler un gaz inerte ou un mélange d'un gaz inerte et d'hydrogène gazeux dans des passages compris entre la cathode et l'anode des torches à plasma individuelles, appliquer une tension entre l'anode et la cathode des torches à plasma individuelles, produire des jets intérieurs non transférables de plasma à courant continu, arrêter la décharge intérieure dans les torches individuelles, associer ensemble plusieurs jets extérieurs transférables de plasma formant un jet de plasma associé uniforme et large, projeter un gaz contenant du carbone ou un mélange d'hydrogène gazeux et d'un gaz contenant du carbone vers la flame du jet de plasma associé, pulvériser le jet de plasma sur un corps formant substrat disposé dans un courant des jets de plasma, et déposer du diamant synthétisé dans une réaction en phase vapeur sur le corps formant substrat.

3. Procédé selon la revendication 1 ou 2, dans lequel un gaz contenant du carbone ou un mélange d'hydrogène gazeux et d'un gaz contenant du carbone est projeté vers les confluences des jets de plasma par des tuyères qui peuvent être déplacées ou inclinées selon les changements de place des confluences des jets de plasma.

4. Procédé selon la revendication 1, 2 ou 3, dans lequel des torches à plasma individuelles peuvent être déplacées en transfert parallèle ou peuvent être tournées en direction angulaire, les torches anodes sont disposées avec leurs axes centraux se rencontrant en un point situé sur un prolongement de la torche cathode avant de produire les jets extérieurs de plasma d'arc entre la torche cathode et les torches anodes, les torches anodes et la torche cathode sont déplacées dans la direction dans laquelle elles reculent en s'éloignant des confluences ou sont tournées dans des directions angulaires dans lesquelles les prolongements des axes centraux des torches s'écartent des premières confluences afin d'élargir le jet associé de plasma.

5. Procédé selon la revendication 1, 2 ou 3, dans lequel plus de deux torches anodes sont installées pour une torche cathode, des jets extérieurs transférables de plasma d'arc peuvent être formés entre la torche cathode et les plusieurs torches anodes, un prolongement de la torche cathode rencontre à angle droit une surface du corps formant substrat, et plusieurs torches anodes sont disposées à des places à symétrie de rotation autour de la torche cathode.

6. Procédé selon la revendication 1, 2 ou 3, dans lequel plus de deux torches cathodes sont installées pour une torche anode, des jets extérieurs transférables de plasma d'arc peuvent être formés entre les torches cathodes et la torche anode, un prolongement de la torche anode rencontre à angle droit une surface du corps formant substrat, et plusieurs torches cathodes sont disposées à des places à symétrie de rotation autour du prolongement de la torche anode.

7. Procédé selon l'une quelconque des revendications précédentes, dans lequel, après qu'un jet extérieur transférable de plasma a été formé entre les torches cathodes et les torches anodes, les jets de plasma transférables sont élargis en augmentant les distances entre les torches cathodes ou les distances entre les torches anodes ou en inclinant les torches cathodes ou les torches anodes.

8. Dispositif pour synthétiser le diamant en décomposant et activant un gaz de matière par un plasma à courant continu produit par une tension continue appliquée entre une anode et une cathode d'une torche à plasma et en pulvérisant le plasma activé sur un corps formant substrat, le dispositif comprenant une chambre à vide, une pompe à vide pour créer le vide dans la chambre à vide, un support pour maintenir le corps formant substrat dans la chambre à vide, une pluralité de torches à plasma situées dans la chambre à vide pour produire un jet de plasma à courant continu, chaque torche à plasma ayant une barre formant cathode et des anodes montées coaxialement autour d'un axe central, les torches à plasma étant disposées dans une disposition conique de telle manière qu'un prolongement de l'axe central de chaque torche rencontre le prolongement des autres torches en un point, une pluralité de tuyères pour projeter un gaz contenant du carbone dans les jets de plasma à courant continu créés par les torches à plasma, des sources d'énergie pour fournir une tension continue, ou une tension continue superposée à une tension à haute fréquence, appliquée entre les cathodes et les anodes des torches à plasma, des connexions électriques pour connecter plusieurs torches à plasma aux sources d'énergie, plusieurs commutateurs prévus dans les connexions électriques pour fournir ou couper la tension d'alimentation aux cathodes ou aux anodes des torches, l'agencement étant tel qu'en utilisation, certaines des torches à plasma agissent comme des cathodes (torches cathodes) et les autres torches à plasma agissent comme des anodes (torches anodes), les torches à plasma étant aptes à former des colonnes individuelles de plasma d'arc dans elles-mêmes en réponse à l'application d'une tension entre la cathode et l'anode, et les torches anodes et les torches cathodes étant aptes à former un jet associé et large de plasma d'arc en réponse à l'actionnement des commutateurs.

9. Dispositif pour synthétiser le diamant en décomposant et activant un gaz de matière par un plasma à courant continu produit par une tension continue appliquée entre une anode et une cathode d'une torche à plasma et en pulvérisant le plasma activé sur un corps formant substrat, le dispositif comprenant une chambre à vide, une pompe à vide pour créer le vide dans la chambre à vide, un support pour maintenir le corps formant substrat dans la chambre à vide, une pluralité de torches à plasma situées dans la chambre à vide pour produire un jet de plasma à courant continu, chaque torche à plasma ayant une barre formant cathode et des anodes montées coaxialement autour d'un axe central, les torches à plasma étant disposées dans une disposition conique de telle manière qu'un prolongement de l'axe central de chacune des torches rencontre les prolongements des autres torches en un point, une pluralité de tuyères pour projeter un gaz contenant du carbone dans les jets de plasma à courant continu créés par les torches à plasma, des sources d'énergie pour fournir une tension continue, ou une tension continue superposée à une tension à haute fréquence, appliquée entre les cathodes et les anodes des torches à plasma, des connexions électriques pour connecter plusieurs torches à plasma aux sources d'énergie, plusieurs commutateurs prévus dans les connexions électriques pour fournir ou couper la tension d'alimentation aux cathodes ou aux anodes des torches, l'agencement étant tel qu'en utilisation, certaines des torches à plasma agissent comme des cathodes (torches cathodes) et les autres torches à plasma agissent comme des anodes (torches anodes), les torches à plasma étant aptes à former des colonnes individuelles de plasma d'arc dans elles-mêmes en réponse à l'application d'une tension entre la cathode et l'anode, les torches anodes et les torches cathodes étant aptes à former un jet associé et large de plasma d'arc par actionnement des commutateurs pour appliquer une tension entre les torches anodes utilisées comme des anodes et les torches cathodes utilisées comme des cathodes, et les torches à plasma étant aptes à être déplacées ou tournées afin de faire varier une aire du jet associé de plasma d'arc.

10. Dispositif selon la revendication 8 ou 9, dans lequel les torches cathodes sont disposées à des positions symétriques en rotation par rapport à une normale menée à partir du centre du corps formant substrat avec un petit angle d'inclinaison inférieur à 45° entre la normale et les lignes axiales des torches cathodes, les torches anodes étant disposées à des positions symétriques en rotation par rapport à la normale avec un grand angle d'inclinaison compris entre 45° et 90° entre la normale et les lignes axiales des torches anodes, les torches anodes et les torches cathodes sont disposées alternativement dans une direction angulaire, et des jets extérieurs transférables de plasma d'arc sont formés entre chaque torche anode et les torches cathodes voisines.

11. Dispositif selon la revendication 8 ou 9, dans lequel une torche cathode est alignée le long d'une normale menée à partir du centre du corps formant substrat, plusieurs torches anodes sont disposées à des positions symétriques en rotation par rapport à la normale avec un angle d'inclinaison compris entre 60° et 120°, et des jets extérieurs transférables de plasma d'arc sont formés entre la torche cathode et toutes les torches anodes.

# F I G. 1

# F I G. 2

# FIG. 3

EP 0 522 842 B1

EP 0 522 842 B1

F I G. 4 (a)

F I G. 4 (b)

F I G. 4 (c)

31

# F I G. 5

FIG.6

# F I G. 7 (a)

# F I G. 7 (b)